# EUROPEAN PATENT APPLICATION

(11) **EP 2 060 907 A1**
(43) Date of publication of application: **20.05.2009**
(21) Application number: 07793047.7
(22) Date of filing: 28.08.2007
(51) Int. Cl.: G01N 21/956, H05K 3/00, H05K 3/34

(54) **BOARD APPEARANCE INSPECTION METHOD AND DEVICE**

(30) Priority: 28.08.2006 JP 2006231276; 28.08.2006 JP 2006231301; 05.12.2006 JP 2006328346
(71) Applicant: I-Pulse Kabushiki Kaisha, Hamamatsu-shi, Shizuoka 431-2103 (JP)
(72) Inventor: KAKUDA, Yoshihisa, Hamamatsu-shi, Shizuoka 431-2103 (JP)
(74) Representative: Müller-Boré & Partner Patentanwälte
(86) International application number: PCT/JP2007/066603
(87) International publication number: WO 2008/026562

(57) **Abstract**

Problem to be Solved

To efficiently perform a board appearance inspection with a simple structure.

Solution

A control unit 60 performs processing for comparing a picked-up image of a board P picked up by a camera 52 with standard image data stored in a memory unit 61 and judging whether the board is good or poor. When the board P is judged to be poor, an image of the board P is displayed on a liquid crystal monitor 4 in order to have an operator visually judge the board P. When the board P is judged to be good by the visual judgment, the picked-up image of the board P that is judged to be good is additionally stored in the memory unit 61 as the standard image data.

## Description

### Technical Field

The present invention relates to a method and device for inspecting the appearance of a board such as a mounting state of parts mounted on the board, a printed wiring pattern on the board, a cream solder printing pattern on the board and the like.

### Background Art

A conventional method for performing an appearance inspection of a board involves comparing a picked-up image of a board with standard image data (master data) to be used as a standard of a good board and inspecting the degree of coincidence between the two (so-called pattern matching method). With the pattern matching method, composing the.standard image data from a single sample image severely limits the number of boards judged to be good and gives rise to a risk where even boards that should be judged to be good in a visual inspection by an operator may end up being discarded as poor boards. Therefore, while a range of the standard image data is desirably given a certain degree of latitude, immoderately widening the standard image data range will now cause boards that should be judged as being poor to be judged good.

In this light, in Patent Document 1 described below, a program based on a self-organizing map (SOM) that is a type of a hierarchical neural network technique is applied when creating standard image data based on one or more sample images. According to the method disclosed in Patent Document 1, standard image data in an appropriate range corresponding to inspection object characteristics (representative statistical data) can be obtained.
Patent Document 1: Japanese Patent Laid-Open No. 2003-044835

However, since the method disclosed in Patent Document 1 described above is configured such that standard image data is obtained through high-level program processing based on a self-organizing map (SOM), not only does manufacturing software require immense costs, but problems also arise in that the capacity of hardware (memory and/or CPU) for running the software must be increased and an increase in processing time is inevitable.

The present invention has been made in consideration of the above circumstances, and an object thereof is to efficiently carry out a board appearance inspection with a more simply structured device.

### Disclosure of the Invention

Such a technical problem can be solved by a board appearance inspection method according to the present invention, which is configured as described below.

That is, the present invention is a method for carrying out an appearance inspection of a board, comprising: an image pickup step for picking up an image of the board using image pickup device; an automatic judgment step for comparing a picked-up image of the board obtained in the image pickup step with standard image data stored in advance in memory as a standard of a good board and causing an automatic judgment device to judge whether the board is good or poor; and a visual judgment step for displaying an image of the board on display when the board is judged to be poor in the automatic judgment step, and having an operator visually judge whether the board is good or poor based on the image displayed on the display, wherein when the board is judged to be good in the visual judgment step, a picked-up image of the board judged to be good is additionally stored in the memory as the standard image data.

### Brief Description of the Drawings

Figure 1 is a perspective view showing a board inspection device according to a first embodiment of the present invention;
Figure 2 is a plan view showing the inspection device;
Figure 3 is a longitudinal cross-sectional view showing an internal structure of the inspection device;
Figure 4 is a plane cross-sectional view showing an internal structure of the inspection device;
Figure 5 is a diagram extracting a portion of Figure 3 which supports a liquid crystal panel;
Figure 6 is a cross-sectional diagram of a base frame showing an assembly structure of a control unit;
Figure 7 is a block diagram showing a control system of the inspection device;
Figure 8 are diagrams for schematically explaining contents of image processing to be performed by the inspection device, wherein Figure 8A shows a picked-up image of a board, Figure 8B shows standard image data, and Figure 8C shows a difference image between Figure 8A and Figure 8B;
Figure 9 is a diagram showing an example of an image displayed on the liquid crystal monitor for a visual judgment by an operator;
Figure 10 is a diagram showing a state where an image of a board has been divided;
Figure 11 is a front-stage portion of a flowchart showing contents of control operations to be executed by the control unit;
Figure 12 is a middle-stage portion of the flowchart;
Figure 13 is a latter-stage portion of the flowchart;
Figure 14 is a diagram showing a general structure of a board inspection system according to a second embodiment of the present invention;
Figure 15 is a block diagram showing a control system of the board inspection system;
Figure 16 is a flowchart showing contents of control operations to be executed by the board inspection system;
Figure 17 is a diagram for explaining a modification of the board inspection system according to the present invention;
Figure 18 is a diagram for explaining a third embodiment of the present invention and shows a displayed image of a first display pattern to be displayed on a liquid crystal monitor;
Figure 19 is a diagram showing a displayed image of a second display pattern to be displayed on the liquid crystal monitor;
Figure 20 is a diagram showing a displayed image of a third display pattern to be displayed on the liquid crystal monitor;
Figure 21 is a diagram showing a displayed image of a fourth display pattern to be displayed on the liquid crystal monitor;
Figure 22 is a flowchart showing procedures for creating a boundary image;
Figure 23 is a diagram showing the extraction of a solder printing area from a picked-up image;
Figure 24 are diagrams for illustrating boundary images, wherein Figure 24A shows a right-side displacement boundary image, and Figure 24B shows a left-side displacement boundary image;
Figure 25 are diagrams for illustrating boundary images, wherein Figure 25A shows an upper-side displacement boundary image, and Figure 25B shows a lower-side displacement boundary image;
Figure 26 are diagrams for illustrating boundary images, wherein Figure 26A shows an area large boundary image, and Figure 26B shows an area small boundary image;
Figure 27 is a flowchart showing contents of control operations by a control unit; and
Figure 28 is a plan view showing a cream solder printing machine according to a fourth embodiment of the present invention.

### Best Mode for Carrying Out the Invention

### <First Embodiment>

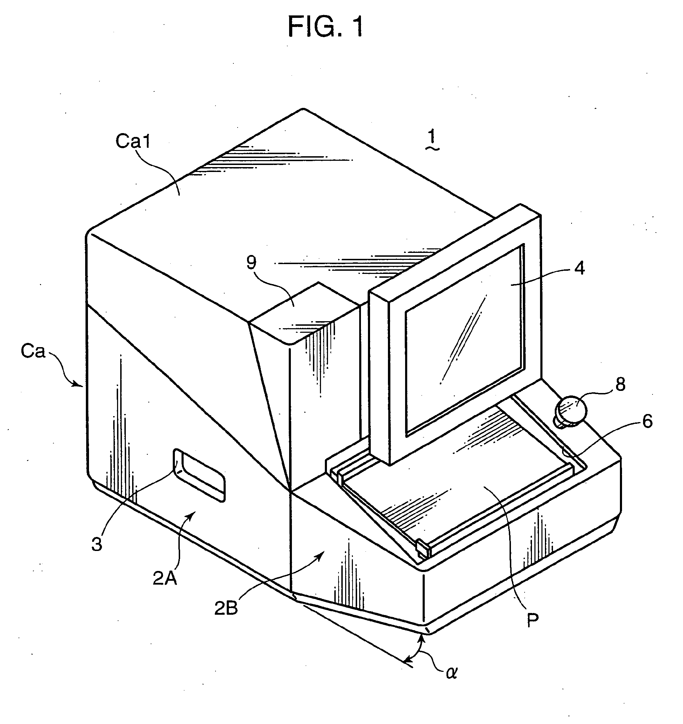

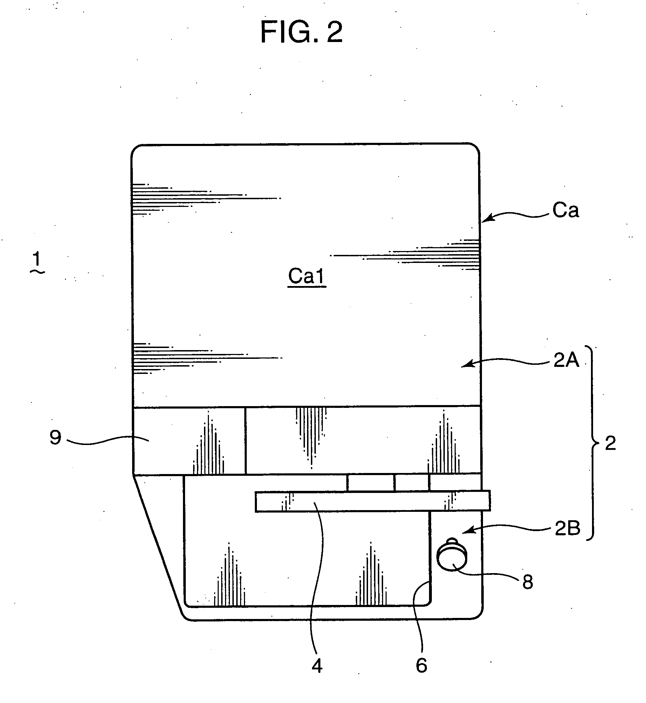

Figures 1 and 2 schematically show a board inspection device 1 according to a first embodiment of the present invention. As shown in the drawings, the inspection device 1 has an A-shaped appearance configuration as viewed laterally in which the entire inspection device 1 is shaped like a box, and is provided with: a rear-side portion 2A constituting a posterior side of the inspection device 1; and a front-side portion 2B that extends forward from a front end lower portion of the rear-side portion 2A. The appearance of such an inspection device 1 is formed by a casing Ca that covers internal parts such as an inspection unit 50 to be described later.

Among the inspection device 1, the front-side portion 2B is provided with an inlet/outlet 6 for taking out and/or putting in a print board P from/to the device. The inlet/outlet 6 is composed of an opening formed on the casing Ca and is provided centrally in the width direction (in Figure 2, at the center in the horizontal direction) of the inspection device 1.

A liquid crystal monitor 4 (corresponding to display according to the present invention) is placed above the inlet/outlet 6 at a front-face portion of the rear-side portion 2A. The liquid crystal monitor 4 is composed of a so-called touch panel liquid crystal display, and in addition to displaying thereon various information such as inspection results, the liquid crystal monitor 4 enables input of various operations to be made to the inspection device 1 by having an operator touch a monitor display by his/her fingertip.

A maintenance door 9 is provided at a portion aligned with the liquid crystal monitor 4 among the front-side portion 2B. The door 9 is a portion of the casing Ca configured so as to be openable/closable, and is arranged so that, by opening the door 9 as necessary, the operator can access the inside of the inspection device 1 to replace a check pen 56, to be described later, and the like. In addition, an upper face cover Ca1 among the casing Ca is arranged so as to be detachable so that maintenance of an image pickup unit 51, to be described later, and the like can be performed in a state where the upper face cover Ca1 is removed.

As shown in Figure 1, a handle 3 composed of a depression is provided at both left and right side portions of the rear-side portion 2A of the casing Ca and enables the inspection device 1 to be portable by holding the handle 3. Moreover, reference numeral 8 in Figures 1 and 2 denotes an emergency stop button.

The inspection device 1 is formed such that the width of the device tapers from the rear side to the front side thereof. More specifically, the width of the inspection device 1 is formed tapered by inclining one of the lateral faces of the front-side portion 2B (in Figure 2, the left lateral face) among the lateral faces of the inspection device 1 constituted by the casing Ca by a predetermined angle α with respect to the front-rear direction. This is a contrivance for compactly installing a plurality of the inspection devices 1 and improving workability, and will be described in a second embodiment of the present invention to be presented later.

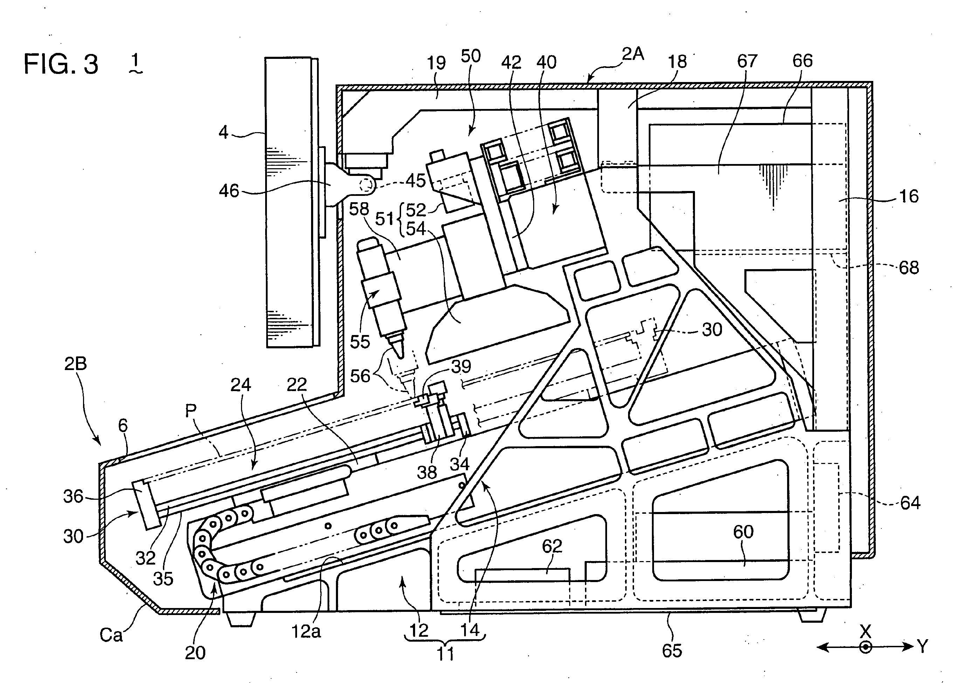

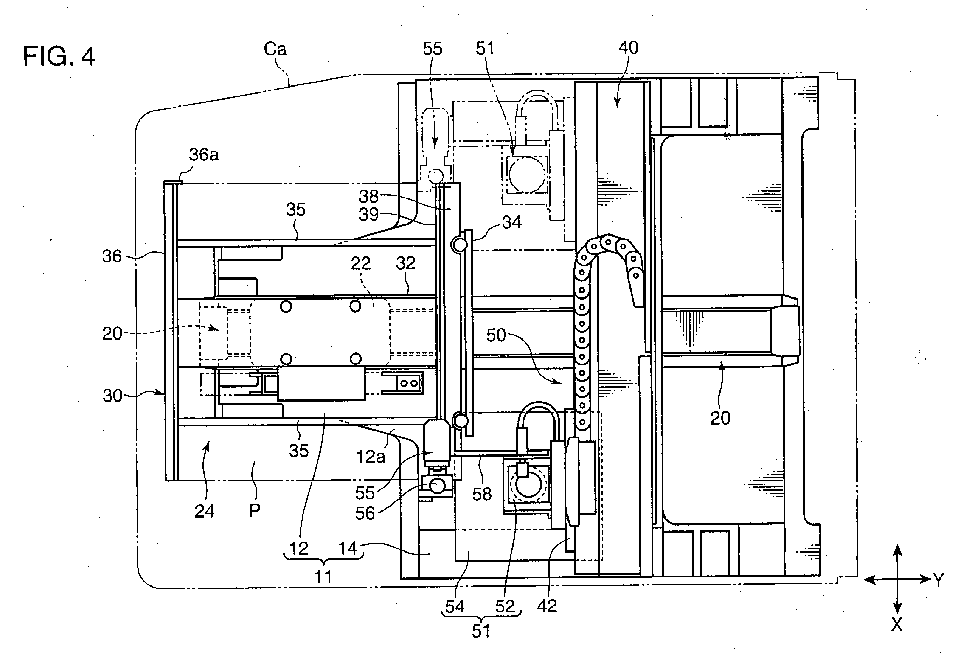

Figures 3 and 4 are diagrams for showing specific internal configurations of the inspection device 1. As shown in the drawings, a base frame 11 is provided inside the inspection device 1. Assembled on the base frame 11 is a board-holding mechanism 24 that holds and moves the print board P, an inspection unit 50 for picking up an image of the board P held by the board-holding mechanism 24, and the like.

The structure of the base frame 11 is integrally provided with: a base portion 12 having a front-sloping inclined face 12a whose height becomes lower the further toward the front side (the side at which the liquid crystal monitor 4 is provided); and side wall portions 14 respectively rising from both left and right ends of the base portion 12. The base frame 11 is composed of a cast piece such as an aluminum die-cast piece.

The board-holding mechanism 24 is composed of a linear motor-type single axis robot 20 fixed onto the inclined face 12a of the base portion 12 and which moves a slider 22 frontward in a front-rear direction along the inclined face 12a (hereinafter, this direction shall be referred to as a Y-axis direction), and a table 30 fixed to the slider 22.

The table 30 holds the print board P, and is configured so as to be movable, in response to the movement of the single axis robot 20, in a Y-axis direction between a home position (the position indicated by the solid line in Figure 3) opposing the inlet/outlet 6 and an inspection position (the position indicated by the dashed-two dotted line in Figure 3) opposing the image pickup unit 51 to be described later. Attaching and/or detaching of the print board P to/from the table 30 is performed at the home position, whereas images of the print board P are arranged to be picked up by the image pickup unit 51 when the table 30 has moved from the home position to the inspection position.

The table 30 includes a plate 32 fixed to an upper face portion of the slider 22 and a pair of front and rear board-holding frames 36 and 38 (hereinafter may sometimes be referred to as the front-side frame 36 and the rear-side frame 38) assembled onto the plate 32 and extending in a left-right direction. The print board P is arranged so as to be held between the frames 36 and 38. More specifically, a movable unit 39 displaceable in a Y-axis direction and biased frontward by an elastic member such as a compression coil spring is provided on the rear-side frame 38 among both frames 36 and 38, and stair-shaped board receiving portions are respectively formed on portions of the movable unit 39 and the front-side frame 36 opposing each other. By placing front and rear edges of the print board P on the board receiving portions to fit the board P between the front-side frame 36 and the movable unit 39 (refer to Figure 3), the board P is elastically sandwiched between both frames 36 and 38 by the elastic force of the compression coil spring or the like, and in response thereof, the print board P is to be held on the table 30 in a state where the print board P is positioned in a Y-axis direction with respect to the front-side frame 36. In addition, a positioning plate 36a is provided on one edge-side in the left-right direction of the front-side frame 36. By having an edge (an edge in the left-right direction) of the print board P abut the plate 36a, the plate P is to be positioned in the left-right direction (hereinafter referred to as an X-axis direction).

The spacing between the front-side and rear-side frames 36 and 38 is arranged so as to be variable depending on the board size. More specifically, an end plate 34 is fixed to a rear end of the plate 32, and a pair of left and right guide bars 35 that are parallel to each other are fixed across the end plate 34 and the front-side frame 36. The rear-side frame 38 is mounted so as to be slidable on the guide bars 35. The guide bars 35 are also provided with a locker, not shown, which is capable of locking the rear-side frame 38 onto the guide bars 35 at an arbitrary position. In other words, the spacing between the front-side and rear-side frames 36 and 38 is configured so as to be variable by sliding the rear-side frame 38 with respect to the front-side frame 36 and locking the rear-side frame 38 at a desired position using the locker.

The inspection unit 50 is provided with a single axis robot 40 that moves the slider 42 in an X-axis direction and the image pickup unit 51 to be assembled onto the single axis robot 40 via the slider 42.

In a similar manner to the single axis robot 20 for driving the table 30, the single axis robot 40 is composed of a linear motor-type single axis robot and is fixed to the base frame 11 in a state where the single axis robot is laid laterally across both side wall portions 14.

The image pickup unit 51 is provided with a camera 52 (corresponding to image pickup device according to the present invention) including: an area sensor such as a CCD, a CMOS image sensor, or the like; and an illuminating device 54 that irradiates an illuminating light onto the print board P that is a subject. The image pickup unit 51 is arranged so that the camera 52 picks up an image of the print board P held by the table 30 from a direction perpendicular to the front face of the print board P. The image pickup unit 51 is configured so as to be movable, in accordance with the movement of the slider 42 in the X-axis direction, to an image pickup position above the single axis robot 20 of a board supplying unit 24 or to positions depicted by the dashed-two dotted line and the solid line in Figure 4. In addition, the image pickup unit 51 is held at the image pickup position during normal times and may also move to the position indicated by the dashed two-dotted line in Figure 4 when replacing a marking unit 55, to be described later, or the like, or to the position indicated by the solid line in Figure 4 during maintenance of the image pickup unit 51 by removing the upper face cover Ca1, or the like.

The inspection unit 50 is mounted with the marking unit 55 which, depending on inspection results or the like, inscribes a predetermined mark onto the print board P. The marking unit 55 comprises a check pen 56 for inscribing a mark and a drive mechanism that drives the check pen 56 forward/backward, and in accordance with the action of the drive mechanism, the check pen 56 is arranged so as to move forward/backward between an operation position (the position indicated by the dashed two-dotted line in Figure 3) at which the check pen 56 abuts the print board P held by the table 30 and a retreat position (the position indicated by the solid line in Figure 3) to which the check pen 56 retreats upward from the operation position.

As shown in Figures 3 and 4, the marking unit 55 is configured such that by being fixed to the image pickup unit 51 via a connecting arm 58, the marking unit 55 integrally moves with the image pickup unit 51 in an X-axis direction. The marking unit 55 is arranged so as to be positioned behind (on rearward side) of the door 9 shown in Figures 1 and 2 at the side of one end (the position indicated by the dashed two-dotted line in Figure 4) in the left-right direction of the movable range thereof. In other words, by opening the door 9 when the marking unit 55 is placed at this position, an operator can readily replace the check pen 56 or the like.

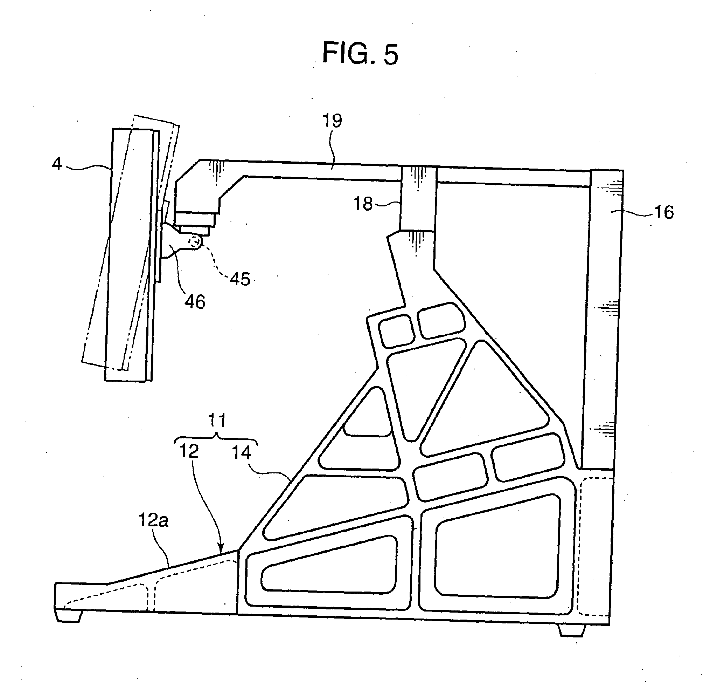

A beam 19 which extends in a front-rear direction is further provided above the base frame 11. As shown in Figure 5, the beam 19 is fixed by a pair of front and rear portal subframes 16 and 18 fixed across both side wall portions 14 of the base frame 11. The liquid crystal panel 4 is supported so as to be tiltable on a tip of the beam 19. More specifically, a joint 46 is connected to a front end portion of the beam 19 in a rotatable state around a spindle 45 extending in an X-axis direction, and by assembling the liquid crystal monitor 4 onto the joint 46, an inclination angle of the liquid crystal monitor 4 with respect to a vertical axis of the same is arranged so as to be variable (the posture of the liquid crystal monitor 4 can be varied in a front-rear direction).

In addition, as shown in Figure 3, a driver 66 which controls driving of the single axis robot 40 of the inspection unit 50 is disposed in a space above the installation portion of the board-holding mechanism 24 and on a rearward side of the inspection unit 50. More specifically, a pair of left and right lateral plates 67 are fixed to both side wall portions 14 of the base frame 11 and to the subframe 18 and a supporting plate 68 is laid laterally across the lateral plates 67, whereby the driver 66 is fixed onto the supporting plate 68.

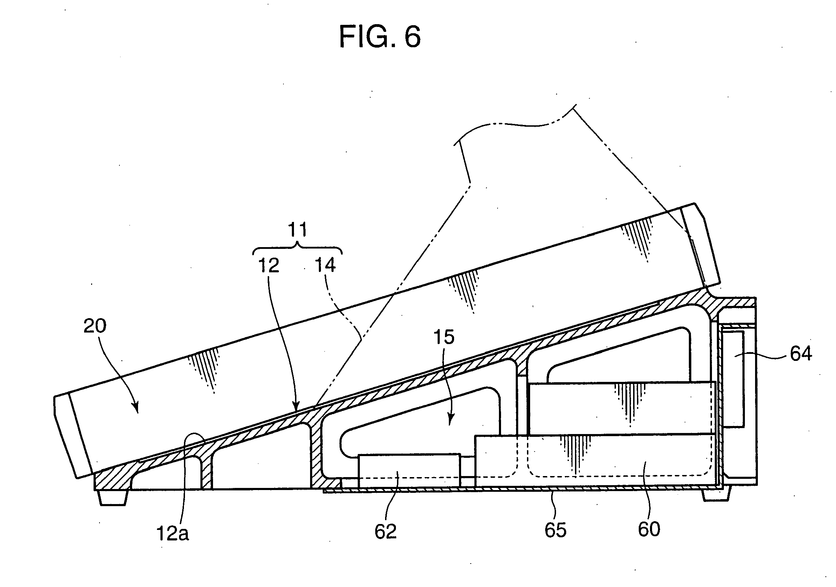

Meanwhile, a control unit 60 responsible for overall control of the inspection device 1, a driver 62 for the single axis robot 20 of the board-holding mechanism 24, and the like are disposed inside the base portion 12 of the base frame 11. In other words, as shown in Figure 6, a space 15 with an approximately triangular cross-section and which opens downward and rearward is formed inside the base portion 12, whereby the control unit 60 and the driver 62 are disposed inside the space 15. Moreover, reference numeral 64 in Figures 3 and 6 denotes a cooling fan for cooling the control unit 60 and the like.

The control unit 60, the driver 62, and the cooling fan 64 are integrally fixed to an under cover 65 primarily covering a lower face portion and a rear face portion of the inspection device 1. The respective devices 60, 62, and 64 are arranged so as to be housed in the space 15 of the base portion 12 of the base frame 11 in a state where the under cover 65 is assembled onto the base portion 12 from the underside.

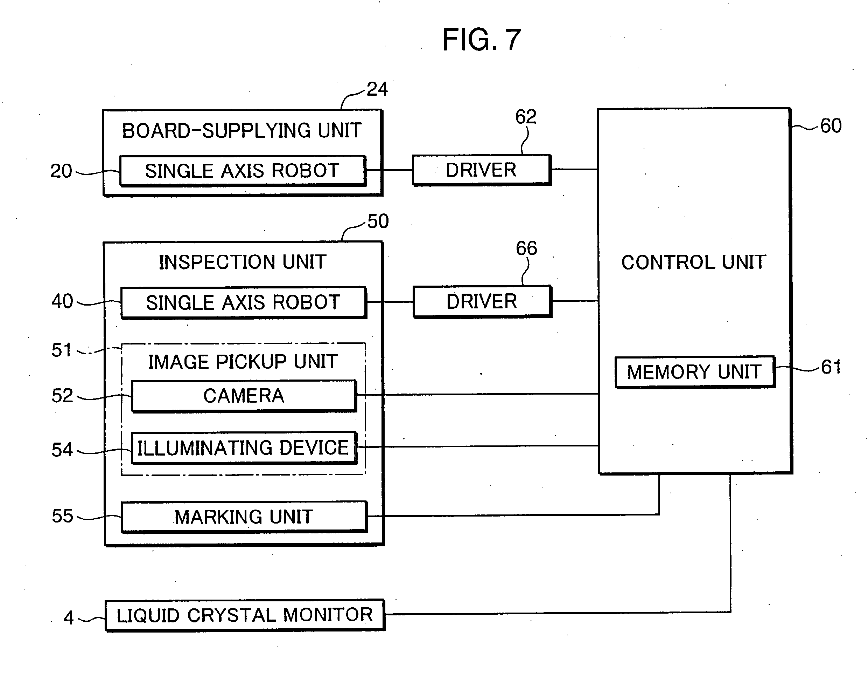

The control unit 60 comprises: a CPU that executes logical operations; a ROM storing various programs and the like which control the CPU; a RAM that temporarily stores various data during operations of the device; an HDD that stores various data and software, and the like. In addition, as shown in the block diagram in Figure 7, electrically connected to the control unit 60 are: the respective single axis robots 20 and 40 for the board-holding mechanism 24 and for the inspection unit 50; the image pickup unit 51 (the camera 52 and the illuminating device 54); the marking unit 55; the liquid crystal monitor 4; and other various sensors and the like, not illustrated. Among the above, the single axis robots 20 and 40 are respectively connected to the control unit 60 via the drivers 62 and 66. In order to perform a series of inspection operations on the print board P according to a pre-stored operation program, the control unit 60 is arranged to: perform overall control of operations of the single axis robots 20 and 40, the image pickup unit 51, and the like; perform operations such as judging whether the print board P is good or poor based on an image picked up by the camera 52; and based on the judgment results, control display contents on the liquid crystal monitor 4.

With the inspection device 1 configured as described above, for example, an inspection of the print board P is executed as described below.

Upon activation, the inspection device 1 is kept in a stand-by state until a test is commenced. In the stand-by state, the table 30 is set at its home position and a predetermined menu screen is displayed on the liquid crystal panel 4.

In this state, as an operator sets the print board P that is an inspection object onto the table 30, touches the liquid crystal panel 4, and selects "start inspection" from the menu screen, an inspection of the board P commences. The print board P is set onto the table 30 by sandwiching the print board P between the board-holding frames 36 and 38 while having a face of the print board P subjected to inspection (the face on the side mounted with parts) facing upward. At this point, positioning of the print board P may be achieved by having the print board P abut the positioning plate 36a.

Once inspection commences, the actuation of the single axis robot 20 causes the table 30 to move in a Y-axis direction while the actuation of the single axis robot 40 causes the image pickup unit 51 to move in an X-axis direction. In response thereto, the camera 52 of the image pickup unit 51 is positioned at a position opposing the print board P, and under illuminating light from the illuminating device 54, an image of the print board P is picked up by the camera 52.

Once an image of the print board P has been picked up by the camera 52 in this manner, based on the picked-up image, the control unit 60 judges whether the appearance of the print board P (more specifically, the mounting state of parts on the print board P) is good or poor. When the judgment results in a poor board, the control unit 60 causes the liquid crystal panel 4 to display the image of the board P, and has the operator perform a visual judgment based on the image of the board P displayed on the liquid crystal panel 4. Furthermore, when the print board P is once again judged to be a poor board by the visual judgment or, in other words, when the print board P is judged to be a poor board by both the automatic judgment by the control unit 60 and the visual judgment by the operator, only then is the print board P processed as a poor board. Specific contents of the good/poor judgment operation on the print board P by the control unit 60 will be described later in detail.

Once the good/poor judgment operation on the print board P is completed in this manner, the table 30 is returned to its home position while the print board P is manually removed from the table 30 by the operator, thereby concluding the inspection on the print board P. By repeatedly performing the inspection procedure described above, appearance inspections are executed in succession on a plurality of print boards P. Upon conclusion of an inspection, when the operator performs a predetermined touch operation on the liquid crystal panel 4, the display on the liquid crystal panel 4 returns to the menu screen and the inspection device 1 is reset to the stand-by state described earlier.

Next, specific contents of the good/poor judgment operation by the control unit 60 and the like will be described. When an image of the face of the print board P subjected to inspection is picked up by the camera 52, the control unit 60 first performs processing for comparing the picked-up image of the board P with standard image data to be used as a standard of a good board. More specifically, the control unit 60, having stored the standard image data in a memory unit 61 (corresponding to memory according to the present invention; refer to Figure 7) provided internally, compares the standard image data with the picked-up image of the print board P picked up by the camera 52 to determine a difference, and judges whether the print board P is good or poor based on the difference image. In other words, an automatic judgment device that judges whether the print board P is good or poor by comparing a picked-up image of the print board P with standard image data is constituted by the control unit 60. Extraction of the difference image is executed in a state where, for example, fiducial marks for position alignment which are provided spaced at a plurality of locations on an upper face (the mounting face) of the print board P are matched between the picked-up image of the print board P and the standard image data in order to align the positions of both images.

While the standard image data stored in the memory unit 61 initially comprises one or more sample images of good boards, as described later, inspection results are to be reflected to add the standard image data accordingly as the inspection progresses. In other words, the standard image data is configured so as to include a plurality of pieces of data in a state where at least a certain number of print boards P have been inspected. In addition, in a case where there is a plurality of pieces of standard image data as described above, the print board P is to be handled as a good board if a comparison with any of the standard image data enables the print board P to be judged as a good board. Therefore, the larger the number of pieces (range) of standard image data, the greater the range of print boards P judged to be a good board.

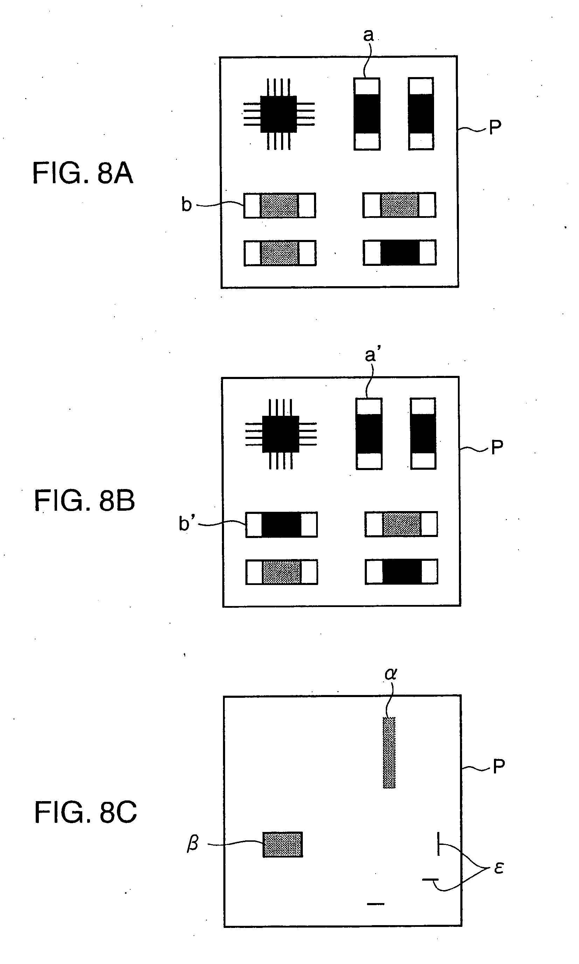

Figure 8 are diagrams for schematically explaining contents of image processing as described above, wherein: Figure 8A shows a picked-up image of the print board P picked up by the camera 52; Figure 8B shows standard image data; and Figure 8C shows a difference image obtained through image processing by the control unit 60. As shown in these drawings, various electronic parts are mounted on the print board P, and in a case where the mounting positions, types, or the like of the electronic parts differ between the picked-up image shown in Figure 8A and the standard image data shown in Figure 8B, a corresponding difference element is to be displayed in the difference image shown in Figure 8C. For example, since a misalignment exists between the mounting positions of an electronic part a shown in Figure 8A and an electronic part a' shown in Figure 8B, a difference element α corresponding to the positional displacement between the respective electronic parts a and a' is to be displayed in the difference image shown in 8C. In addition, since an electronic part b shown in Figure 8A and an electronic part b' shown in Figure 8B differ from each other in type, a difference element β corresponding to the difference in surface colors or the like between the respective electronic parts b and b' is to be displayed in the difference image shown in 8C. Moreover, in addition to the difference elements α and β described above, the difference image shown in Figure 8C also displays minute difference elements such as that denoted by reference character ε.

Once having extracted a difference image such as that shown in Figure 8C through predetermined image processing, the control unit 60 next judges whether the area of each difference element (α, β and the like) is equal to or below a predetermined upper limit. If so, the control unit 60 judges that the print board P is a good board, and if not, judges that the print board P is a poor board. Hereinafter, for the present embodiment, an upper value of the area of a difference element shall be referred to as an upper limit difference area A.

When the print board P is judged to be a poor board by an appearance inspection of the same through image processing such as described above, an image of the print board P is displayed on the liquid crystal monitor 4, and a final decision will be left to a visual judgment by the operator.

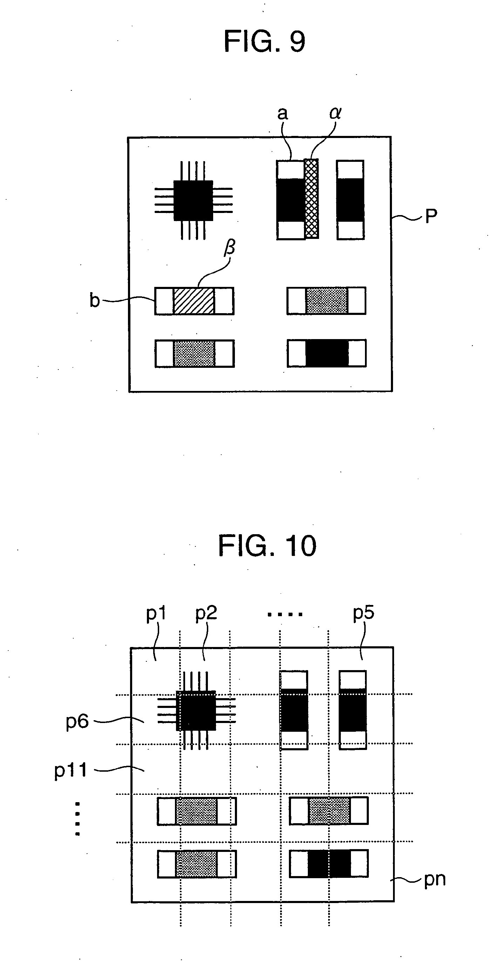

Figure 9 shows an image of the print board P displayed on the liquid crystal monitor 4 as an image for a visual judgment by the operator. As shown in the diagram, an image that combines the picked-up image of the print board P shown in Figure 8A and the difference image shown in Figure 8C is displayed on the liquid crystal monitor 4. In this case, the difference element whose area is equal to or smaller than the upper limit difference area A (ε in Figure 8C) is omitted while difference elements α and β that are larger than the upper limit difference area A are displayed colored in different colors in accordance with characteristics of the differences. This is a measure to further facilitate visual judgment by the operator, and coloring is applied so that, for example, the difference element α attributable to the positional displacement of electronic parts is colored in blue, the difference element β attributable to the difference in type of electronic parts is colored in red, and so on.

The operator performs a visual judgment of the print board P while viewing such a display screen of the liquid crystal monitor 4, and inputs results thereof through touch operations of the liquid crystal monitor 4. In other words, input device which the operator uses to input a visual judgment result is constituted by the liquid crystal monitor 4.

In the case where the print board P is once again judged to be a poor board as a result of the visual judgment, the marking unit 55 operates to issue an NG mark on the print board P and a warning alarm is generated. On the other hand, in the case where the print board P is judged to be a good board as a result of the visual judgment, the control unit 60 causes the picked-up image of the print board P to be additionally stored in the memory 61 as the standard image data. In other words, controller that adds a picked-up image of the print board P judged to be a good board by a visual judgment by the operator to the standard image data is constituted by the control unit 60. As a result, in subsequent inspections, a print board P in a similar part-mounting state will be judged to be a good board by an automatic judgment by the control unit 60 based on the added standard image data, thereby absolving the operator from performing a visual judgment all of the time on a similar board P. In addition, since the number of images of the print board P to be added as standard image data as described above increases as more print boards P are inspected, the frequency at which the operator performs visual judgment decreases accordingly.

With respect to a good/poor judgment of the print board P, while a judgment is performed in the example shown in Figures 8 and 9 using overall images of the print board P, it is also possible to perform a good/poor judgment by dividing an image of the print board P into a plurality of partitions. Hereafter, the present embodiment will be described along such an example. In this case, firstly, in an automatic judgment performed by the control unit 60, a picked-up image of the print board P is divided into a plurality of partitions p1, p2, ... as shown in Figure 10. Meanwhile, in correspondence thereto, the standard image data is stored in the memory unit 61 as respective independent standard images for each of the segments p1, p2, .... By respectively comparing each partition image of the divided picked-up image with standard image data of a corresponding partition, a difference image is extracted for each partition p1, p2, ... and an area of the difference element is calculated, whereby a judgment on whether the print board P is good or poor is performed based on whether the area is equal to or smaller than a predetermined upper limit difference area A. The division of the picked-up image is performed by reading fiducial marks for position alignment provided spaced at a plurality of positions on the print board P, and clipping images of the respective partitions p1, p2, ... whose positions are set with reference to the fiducial marks from the picked-up image. By comparing a picked-up image of each partition obtained in this manner with standard image data of a corresponding partition in a state where the positions of the picked-up image and the standard image data are aligned (for example, a state where the respective corner positions of diagonals of partitions are matched), a difference image is extracted for each partition p1, p2, ....

The number of the respective partitions p1, p2, ... (the number of image divisions) and sizes thereof are to be appropriately set according to the size of the print board P, the mounting state of parts thereon, or the like. For instance, since parts whose sizes are approximately the same are mounted in the example shown in Figure 10, the picked-up image of the print board P is divided into partitions (p1 to pn) whose sizes are more or less uniform. However, when parts whose sizes significantly differ from each other are mounted on the print board P, images at a portion in which large-size parts are mounted are broadly divided while images at a portion in which small-size parts are mounted are finely divided. In correspondence thereto, the upper limit difference area A is set such that the larger the parts, the greater the value, and the smaller the parts, the smaller the value. In other words, generally, since the mounting accuracy required for large parts is not that high while small parts conversely require a relatively high mounting accuracy, images of smaller parts are to be partitioned more finely to evaluate differences more rigorously.

In a good/poor judgment by image processing as described above, the control unit 60 judges the print board P to be a poor board when a difference element greater than the upper limit difference area A is confirmed in any of the respective partitions p1, p2, .... Then, in a visual judgment subsequently performed by the operator, an image (a combination of a picked-up image of the partition and a difference image of a corresponding partition) of a partition in which a difference element greater than the upper limit difference area A had been confirmed is displayed on the liquid crystal monitor 4, whereby the operator performs visual judgment while viewing the image. At this point, the finer the division of a partition, the higher the magnification of the image displayed on the liquid crystal monitor 4. Accordingly, preferable visibility during visual judgment is ensured.

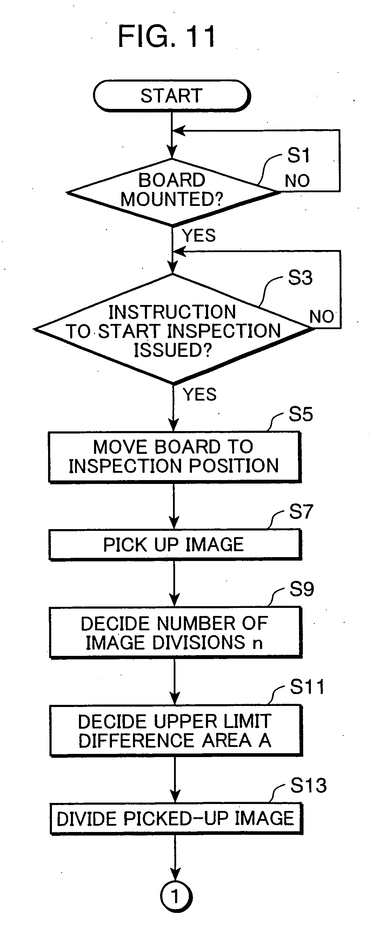

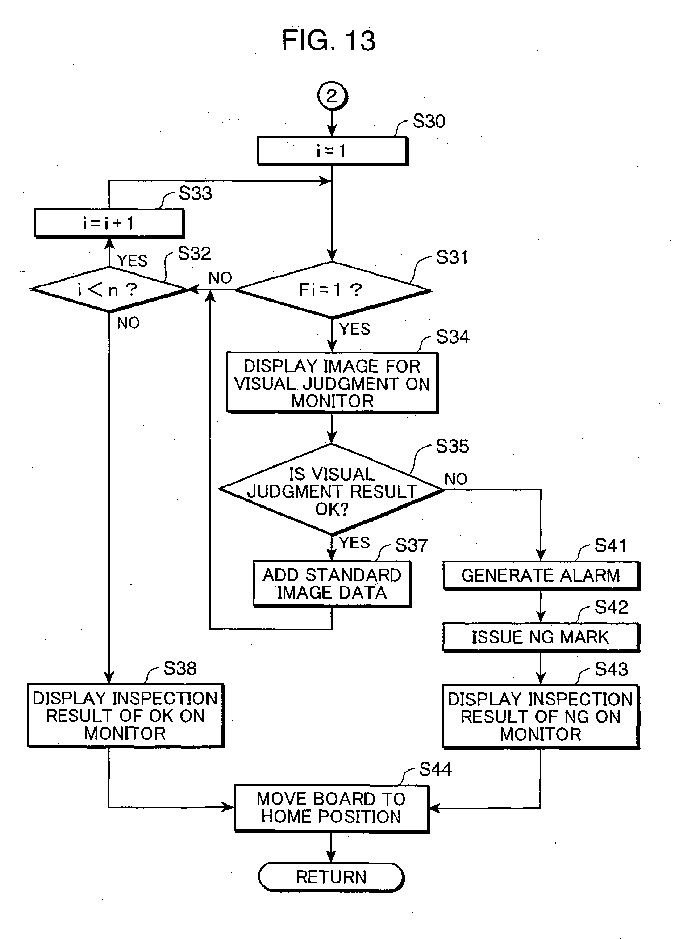

Next, a control operation by the control unit 60 in the inspection device 1 configured as described above will be explained with reference to the flowcharts shown in Figures 11 to 13. Following the start'of the control operation, the control unit 60 waits for the print board P to be set on the table 30 of the board-holding mechanism 24 and for instructions to start an inspection to be inputted to the liquid crystal panel 4 (steps S1, S3) and executes control for moving the print board P to the inspection position (step S5). More specifically, upon confirming that the print board P has been set on the table 30 at its home position (refer to the solid line in Figure 3) through the inlet/outlet 6 and that a touch operation has been performed on the liquid crystal panel 4 to select "start inspection" from the menu screen thereof, the single axis robot 20 is activated to move the table 30 in a Y-axis direction. In response thereto, the print board P is moved to the inspection position indicated by the dashed two-dotted line shown in Figure 3.

Next, the control unit 60 executes control for picking up an image of the print board P using the camera 62 of the image pickup unit 51 (step S7). More specifically, the single axis robot 40 is activated to align the position of the image pickup unit 51 above the print board P that is in the inspection position and an illuminating light is irradiated by the illuminating device 54 to illuminate the print board P. In this state, a control signal is outputted to the camera 52 to pick up an image of the print board P.

Then, in addition to determining the number of image divisions n as the number of division in which the picked-up image of the print board P is to be divided in a subsequent step (step S9), a control is executed for determining an upper limit difference area A to be used as a standard when judging whether the print board P is good or poor on the basis of the divided images. These values are determined in advance per type of the print board P classified according to the size, the mounting state of parts or the like of the print board P, and stored in the memory unit 61. The value of the upper limit difference area A may be set to a constant value or, depending on the mounting state of parts, may be set so as to increase/decrease for each part or each partition. Subsequently, depending on the number of image divisions n determined in step S9, the control unit 60 executes control for dividing the picked-up image of the print board P picked up using the camera 62 (step S13). Due to this processing, the picked-up image is divided as, for example, shown in Figure 10, and images of first to nth partitions (p1, p2, ...pn) are formed. Then, i=1 is set as the number of a partition for which difference area judgment processing, to be performed in a subsequent step, is to be performed first (step S15).

Next, the control unit 60 reads standard image data of an ith partition from the memory unit 61 (step S17), and executes control for calculating an area s of the difference element inside each partition (p1, p2, ...) by comparing the standard image data with a picked-up image of each partition of the print board P divided in step S13 and calculating a difference (step S19). Then, judgment is made on whether the area s is equal to or below the upper limit difference area A determined in step S11 (step S21).

In the case where YES is judged in step S21 and the area s of the difference element in the subject partition is confirmed as being equal to or lower than the upper limit difference area A or, in other words, when it is confirmed that a discrepancy such as a significant positional displacement of electronic parts in the partition does not exist, the flow proceeds to a next step S23 to judge whether the difference area judgment processing in step S21 has been executed for all partitions. More specifically, a judgment is made on whether the number of partitions on which difference area judgment processing has so far been performed has reached the number of image divisions n determined in step S9 or not (i.e., whether i=n or not). In the case where NO is judged in step S23 and it is confirmed that difference area judgment processing has not yet been performed on all partitions, the object of the judgment processing is shifted to the next partition (step S25), and the processing is repeatedly performed until difference area judgment processing has been performed on all partitions.

In the case where NO is judged in step S21 and the area s of the difference element in the subject partition is confirmed as being greater than the upper limit difference area A or, in other words, when it is confirmed that a discrepancy such as a significant positional displacement of electronic parts in the partition may exist, the flow proceeds to a next step S27 to judge whether other standard image data exists for the corresponding partition. When YES is judged at this point to confirm that other standard image data exist, the flow returns to step S15 to repeat difference area judgment processing as described above using the new standard image data as a standard. On the other hand, when NO is judged in step S27 to confirm that other standard image data does not exist, a control is executed for inputting "1" to an NG occurrence flag Fi (whose default value is 0) corresponding to the partition (step S29), and the flow returns to step S23. In other words, an NG occurrence flag Fi of 1 at this point signifies that a difference element greater than the upper limit difference area A exists in all comparisons between a picked-up image of the ith-partition of the print board P and all data stored in the memory unit 61 as standard image data of the same ith partition, indicating that the judgment result (automatic judgment result) of the print board P based on the ith-partition difference image is that of a poor board.

In addition, in the case where YES is judged in step S23 to confirm that difference area judgment processing has been concluded for all partitions, the flow proceeds to a next step S31 to reset the partition number to i=1, and a judgment is made on whether an NG occurrence flag Fi corresponding to each partition is 1 or not among the sequence from the first partition (p1) to the nth partition (pn) (step S31). When NO (Fi=0) is judged at this point, after proceeding to step S32 and confirming that i<n (YES in step S32), 1 is added to the partition number i (step S33) and processing from step S31 is repeated on the new partition. On the other hand, when YES is judged in step S31 to confirm that Fi=1 or, in other words, when it is confirmed that a partition having a difference element greater than the upper limit difference area A exists, control is executed which causes the liquid crystal monitor 4 to display an image for visual judgment for the partition at which Fi=1 (step S34). More specifically, an image resulting from combining the difference image of the ith partition of the print board P extracted in step S19 with the picked-up image of the ith partition and further performing coloring processing described above (processing in which difference elements are colored in colors corresponding to difference characteristics) and the like thereon is displayed on the liquid crystal monitor 4. Then, judgment is made on whether the result of a visual judgment performed based on the ith-partition image displayed on the liquid crystal monitor 4 is OK (good) or not (step S35). More specifically, a judgment is made on whether or not an operation signal indicating that the judgment result was OK has been inputted from the liquid crystal panel 4 by a touch operation of the same performed by the operator.

When NO is judged in step S35 to confirm that the result of the visual judgment by the operator for the partition is NG (poor), a warning alarm is generated (step S41) and, at the same time, a control is executed in which the marking unit 55 is activated to issue an NG mark to the print board P (step S42). Then, after displaying information to the effect that the print board P is a poor board on the liquid crystal monitor 4 (step S43), a control is executed for restoring the table 30 to its home position at which the print board P can be detached (step S44).

On the other hand, when YES is judged in step S35 to confirm that the result of the visual judgment by the operator is OK, a control is executed for additionally storing the picked-up image of the partition judged to be OK in the memory unit 61 in association with the partition number as standard image data of the partition (step S37). Subsequently, the flow proceeds to step S32 to judge whether or not the processing described above has been executed for all partitions.

In the case where YES (i<n) is judged in step S32 to confirm that unprocessed partitions still remain, 1 is added to the partition number i (step S33) and processing from step S31 is repeated on the new partition.

On the other hand, when NO is judged in step S32 to confirm that i=n or, in other words, that either NG occurrence flag Fi=0 for all partitions for which i=1 through n, or even if a partition for which Fi=1 (an NG partition) existed, the result of a visual judgment by the operator is OK, after displaying information to the effect that the print board P is a good board on the liquid crystal panel 4 (step S38), the flow proceeds to step S44 to restore the print board P to its home position.

While an image of the print board P has been divided into a plurality of partitions p1, p2, ... and processing such as difference area judgment has been performed for each partition in the above-mentioned flowchart, as described earlier, whether the print board P is good or poor can be judged by comparing a picked-up image of the entire print board P with corresponding standard image data of the entire print board P to extract a difference image, and judging whether the area of the difference element is equal to or below an upper limit value. When the difference area is equal to or greater than the upper limit value, an image resulting from adding the difference image to the picked-up image of the entire print board P is displayed on the liquid crystal monitor 4 to have the operator perform a visual judgment, and when the print board P is judged to be a good board as.a result of the visual judgment, the picked-up image of the entire print board P judged to be a good board is additionally stored in the memory unit 61 as new standard image data.

As described above, since the first embodiment is arranged so as to cause the control unit 60 to judge whether the print board P is good or poor based on a comparison between a picked-up image of the print board P picked up by the camera 52 and standard image data stored in the memory unit 61, and when the print board P is judged to be a poor board, display an image of the board P on the liquid crystal monitor 4 and have the operator perform a visual judgment, while when the print board P is judged to be a good board, additionally store the picked-up image of the print board P judged to be a good board as the standard image data in the memory unit 61, results of visual judgments by the operator can be sequentially reflected on the standard image data as the inspection progresses, thereby enabling automatic judgment by the control unit 60 based on standard image data of an appropriate range obtained accordingly to be performed with more appropriate accuracy and higher efficiency.

In other words, with the first embodiment, since the control unit 60 initially judges whether the print board P is good or poor based on a small amount of standard image data, the range of the print board P to be judged by the control unit 60 to be a good board is relatively narrow. However, once a certain number of boards P has been inspected, since an image of a print board P judged to be a good board by a visual judgment by the operator (the judgment result by the control unit 60 reversed by the visual judgment by the operator to a good board) is sequentially added as standard image data, the control unit 60 subsequently automatically judges whether a board P is good or poor based on standard image data of an appropriate range on which the judgment result of the visual judgment has been reflected, making it possible to inspect the print board P with appropriate accuracy and with high efficiency comparable to an actual visual judgment by the operator.

In addition, according to the first embodiment, since the range of the standard image data can be made more appropriate by a simple structure of sequentially additionally storing images of a print board P judged to be a good board by a visual judgment by the operator in the memory unit 61, unlike a conventional technique that required complicated program processing to be performed, effects such as cost reduction, reduction in processing time, or the like with respect to the device 1 may be achieved.

Furthermore, as is the case with the first embodiment, when it is arranged that whether the print board P is good or poor is to be judged based on a difference image obtained by a comparison between a picked-up image and standard image data of the print board P, an advantage may be achieved in that a judgment of whether the print board P is good or poor can be efficiently performed with a simple structure involving only determining a difference between two types of images.

Moreover, as is the case with the first embodiment, when it is arranged that whether the print board P is good or poor is to be judged by dividing a picked-up image of the print board P into a plurality of partitions, and comparing a picked-up image of each divided partition with standard image data stored in correspondence thereto for each partition to extract a difference image for each partition, an advantage may be achieved such as being able to judge whether the mounting state of each electronic part mounted on the print board P is good or poor with an appropriate accuracy corresponding to the size of the part even when dimensions of parts significantly differ from each other or the like, making it possible to appropriately perform an appearance inspection of the print board P regardless of any mounted parts.

In addition, as is the case with the first embodiment, when difference elements are arranged to be colored in difference colors according to difference characteristics (for example, according to whether a difference has occurred due to a positional displacement of mounting parts on the print board P or due to a difference in part types) upon displaying the difference image on the liquid crystal monitor 4 as an image for visual judgment by the operator, an advantage may be achieved in that visibility during the visual judgment can be effectively improved to make the visual judgment by the operator more efficient and the like.

Furthermore, as is the case with the first embodiment, when a board-holding mechanism 24 that moves the print board P between a home position at which attaching and detaching of the print board P is performed and an inspection position at which an image of the print board P is picked up by the camera 52 is provided inside the inspection device 1, since merely setting the print board P to the home position automatically executes a subsequent series of operations or, in other words, operations such as moving the print board P to the inspection position or restoring the same to the home position after image pickup, usability of the inspection device 1 can be effectively improved. In addition, since various devices including the board-holding mechanism 24, the camera 52, the control unit 60 and the like are arranged so as to be integrally assembled via a common base frame 11 and therefore portable, an advantage may be achieved in that the space occupied by the device can be reduced and the inspection device 1 can be used anywhere without discrimination.

Furthermore, while the first embodiment has been arranged so as to sequentially and additionally store picked-up images of the print board P judged to be a good board through a visual judgment by the operator in the memory unit 61 as standard image data, a configuration is also possible in which addition of subsequent data is no longer executed once a certain number (e.g., 100 or 200) of picked-up images have been added. Such an arrangement prevents an unduly increase in standard image data and enables efficient inspections to be continued.

Moreover, while the first embodiment has been arranged so that the result of a visual inspection by the operator is determined through a touch operation on the liquid crystal monitor 4 by the operator, when an operation by the operator is not performed even when a predetermined period of time has lapsed, the print board P may be judged to be a poor board at that point, whereby the flow proceeds to the next processing.

In addition, while the first embodiment has been arranged so that an image of the entire print board P is first picked up using the camera 52 and is then divided into respective partitions p1, p2, ..., images of the respective partitions p1, p2, ... may instead be picked up by sequentially moving the image pickup unit 51 in an X-direction while moving the table 30 in the Y-direction, and sequentially positioning the camera 52 in accordance thereto to positions opposing the respective partitions p1, p2, .... Such an arrangement enables images with further improved resolution to be obtained, thereby enabling appearance inspections to be performed at high accuracy even on a print board P mounted with small parts.

Furthermore, in the first embodiment, while display for displaying images and input device for accepting operations by the operator have been configured by the same liquid crystal monitor 4 through the use of a touch panel liquid crystal display as the liquid crystal monitor 4, the input device and the display may be configured separately by providing a keyboard or the like separate from the liquid crystal monitor 4 as the input device.

Moreover, in the first embodiment, while the liquid crystal monitor 4 (input device and display) has been provided integrally with the inspection device 1, a visual judgment by the operator may be arranged to be performed using a device separate from the inspection device 1 by providing the display and/or the input device as a separate body from the inspection device 1. On the other hand, as is the case with the first embodiment, when an automatic judgment and a visual judgment on the print board P are arranged to be performed using the same device by integrally providing the liquid crystal monitor 4 as the display and the input device with the inspection device 1, an advantage may be achieved in that an appearance inspection of the print board P can be performed with a simple and compact structure.

In addition, boards to become objects of inspection of the inspection method and device according to the present invention need not be limited to a print board, and may instead be, for example, a board in which a circuit is formed on a lead frame.

Moreover, while an example in which an appearance inspection of the print board P is carried out by a single inspection device 1 has been described for the first embodiment, a plurality of aligned inspection devices 1 is desirably used to further improve inspection efficiency on the print board P. Furthermore, in this case, the inspection efficiency on the print board P may be more effectively improved by having the plurality of inspection devices 1 operate in cooperation with each other to construct a single inspection system. Next, a specific example of a case that adopts the above-mentioned configuration will be described based on a second embodiment presented below.

### <Second Embodiment>

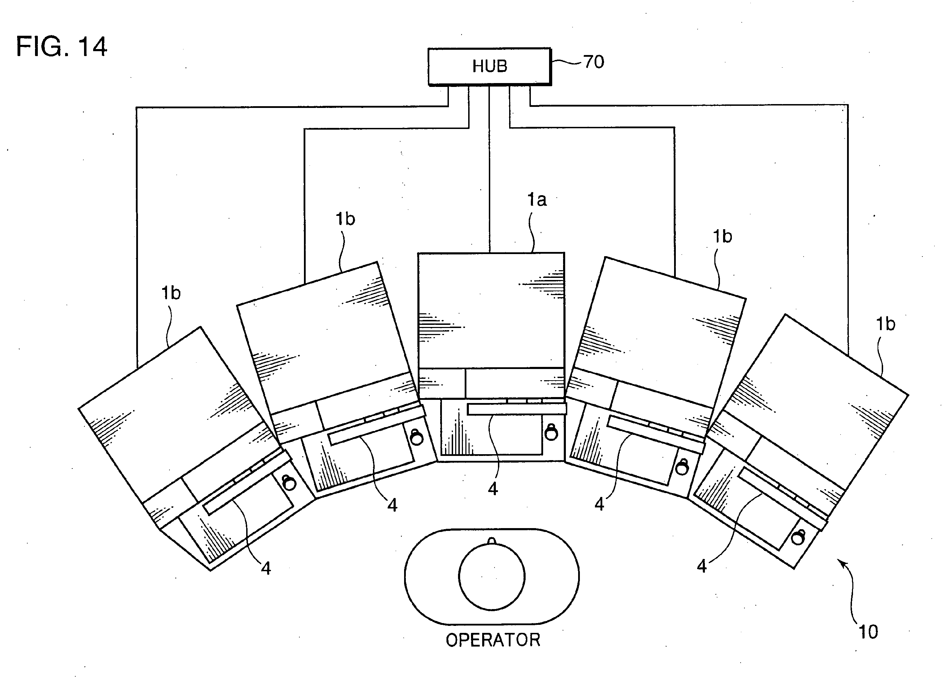

Figure 14 schematically shows a board inspection system according to the second embodiment of the present invention. A board inspection system 10 shown in the present drawing comprises a plurality (five in the example shown) of horizontally aligned inspection devices 1a, 1b, 1b, ... which are network-connected via a hub 70. The respective inspection devices 1a, 1b, 1b, ... share the same basic structure as the inspection device 1 according to the first embodiment, and are provided with a function for judging whether a print board P (refer to Figure 1 and the like) supplied by the operator is good or poor by picking up an image of the print board P and performing image processing or the like thereon. Among the inspection devices, a central inspection device 1a is provided with, in addition to a function for performing inspection processing such as described above, a function for displaying an image of a print board P judged by the device itself (the inspection device 1a) or another device (an inspection device 1b) to be a poor board on its liquid crystal monitor 4 for a visual judgment by the operator, and the like. In other words, in addition to a function as an inspection device that automatically judges whether a board is good or poor, the central inspection device 1a is provided with a function as a visual judgment machine that displays images and the like for visually judging the print board P. Hereinafter, the central inspection device 1a shall be referred to as a master inspection device 1a and other inspection devices 1b as slave inspection devices 1b.

The master inspection device 1a and the slave inspection devices 1b, 1b, ... have similar mechanical structures as the inspection device shown in Figures 1 to 6 in the first embodiment. The formation of the respective inspection devices 1a, 1b, 1b, ... so as to taper toward a front side (the side of a liquid crystal monitor 4) is also similar to the first embodiment (refer to Figures 1 and 2). As a result, in the state shown in Figure 14 in which the five inspection devices 1a, 1b, 1b, ... are placed in a line, the inspection devices 1a, 1b, 1b, ... are to be arranged in an approximately fan-like shape around a position at which the operator stands. Consequently, an advantage may be achieved in that the inspection system 10 is compactly configured and workability of inspection work by the operator is improved.

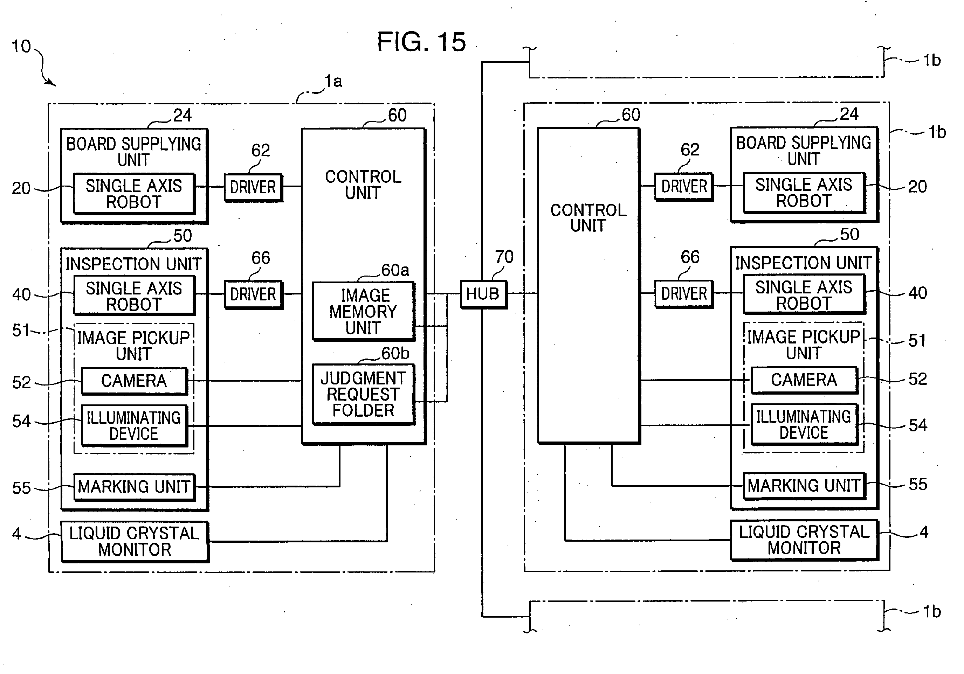

Next, a control system of the board inspection system 10 will be described using a block chart shown in Figure 15. Electrically connected to each control unit 60 of the master inspection device 1a and the slave inspection devices 1b, 1b, ... are: an image pickup unit 51 (a camera 52 and an illuminating device 54); a marking unit 55; a liquid crystal monitor 4; respective single axis robots 20 and 40 for a board supplying unit 24 and for an inspection unit 50; and other various sensors and the like, not illustrated, inside each inspective device.

The control unit 60 of the master inspection device 1a differs from that of the slave inspection devices 1b in that the control unit 60 is provided with an image memory unit 60a (corresponding to the memory according to the present invention) and a judgment request folder 60b. The image memory unit 60a stores standard image data to be used as a standard when judging whether a print board P is good or poor, while the judgment request folder 60b is arranged so as to store images and the like for visually judging a print board P judged to be poor at the master inspection device 1a or a slave inspection device 1b. In addition, the control unit 60, the image memory unit 60a, and the judgment request folder 60b of the master inspection device 1a are electrically connected to the control units 60 of the slave inspection devices 1b via the hub 70.

The respective control units 60 of the master inspection device 1a and the slave inspection devices 1b are configured so as to control overall operations of the board supplying units 24, the inspection units 50, and the like according to a pre-stored operation program for the purpose of carrying out a series of inspection operations on a print board P supplied to each inspection device 1a, 1b, 1b, ..., and to perform processing such as judging whether a print board P is good or poor based on an image picked up by the camera 52 of the inspection unit 50.

With the board inspection system 10 configured as described above, for example, an inspection of a print board P is executed as described below.

Upon activation, the master inspection device 1a and the slave inspection devices 1b, 1b, ... are respectively kept in a stand-by state until a test is commenced. In this stand-by state, at each of the inspection devices 1a, 1b, 1b, ..., the table 30 of the board supplying unit 24 is set at its home position and a predetermined menu screen is displayed on the liquid crystal panel 4.

In this state, as an operator sets a print board P to any of the master inspection device 1a and the slave inspection devices 1b, 1b, ... and further performs a touch operation on the liquid crystal panel 4 to select "start inspection" from the menu screen, an inspection of the board P commences at the inspection device 1a or 1b. Moreover, setting of the print board P to each of the inspection devices 1a, 1b, 1b, ... is performed by setting the print board P on the table 30 at its home position. In other words, the print board P is set onto the table 30 by abutting the print board P against a positioning plate 36a of the table 30 with a face thereof subjected to inspection (the face on the side mounted with parts) facing upward, and sandwiching the positioned print board P between the board-holding frames 36 and 38.

Once inspection commences, at the inspection device 1a or 1b to which the print board P has been set, the actuation of the single axis robot 20 causes the table 30 to move in a Y-axis direction while the actuation of the other single axis robot 40 causes the image pickup unit 51 to move in an X-axis direction. In response thereto, the camera 52 of the image pickup unit 51 is positioned at a position opposing the print board P, and under illuminating light from the illuminating device 54, an image of the print board P is picked up by the camera 52.

Once an image of the print board P has been picked up by the camera 52, based on the picked-up image, processing is performed for judging whether the appearance of the print board P (more specifically, the mounting state of parts on the print board P) is good or poor. The good/poor judgment processing is executed at the control unit 60 of the inspection device 1a or 1b at which the image of the print board P was picked up. When the judgment results in a poor board, the control unit 60 causes the liquid crystal panel 4 of the master inspection device 1a to display a picked-up image of the print board P which has been subjected to predetermined image processing, and has the operator perform a visual judgment based on the image of the board P displayed on the liquid crystal panel 4. Furthermore, when the print board P is once again judged to be a poor board by this visual judgment or, in other words, when the print board P is judged to be a poor board through both the automatic judgment by the control unit 60 and the visual judgment by the operator, only then is the print board P processed as a poor board.

When the good/poor judgment operation of the print board P is completed in this manner, the judgment result is displayed on the liquid crystal panel 4 of the inspection device 1a or 1b at which the image of the print board P was picked up, and in response to the movement of the table 30, the print board P is returned to the home position. The operator then removes the print board P from the table 30, and in accordance with the display on the liquid crystal monitor 4, puts the print board P into an assortment tray or the like, not shown. Accordingly, the inspection on a single board is concluded. By successively executing the inspection procedure described above at the respective inspection devices 1a, 1b, 1b, ... at respectively staggered timings, appearance inspections on a plurality of print boards P will be performed concurrently.

Next, specific contents of good/poor judgment operations on a print board P and the like to be executed by the respective inspection devices 1a, 1b, 1b, ... will be described. When an image of the face of the print board P subjected to inspection is picked up by the camera 52 of each of the inspection devices 1a, 1b, 1b, ..., the control unit 60 of that inspection device 1a or 1b first performs processing for comparing the picked-up image of the board P with standard image data to be used as a standard of a good board. The standard image data is intensively stored in the image memory unit 60a (Figure 15) provided at the control unit 60 of the master inspection device 1a. The control unit 60 of each of the inspection devices 1a, 1b, 1b, ... reads out the standard image data from the image memory unit 60a of the master inspection device 1a, compares the standard image data with the image of the print board P picked up by the camera-52 to determine a difference, and judges whether the print board P is good or poor based on the difference image. Since specific contents of image processing for performing difference image extraction and the like are similar to the first embodiment, a detailed description thereof will be omitted.

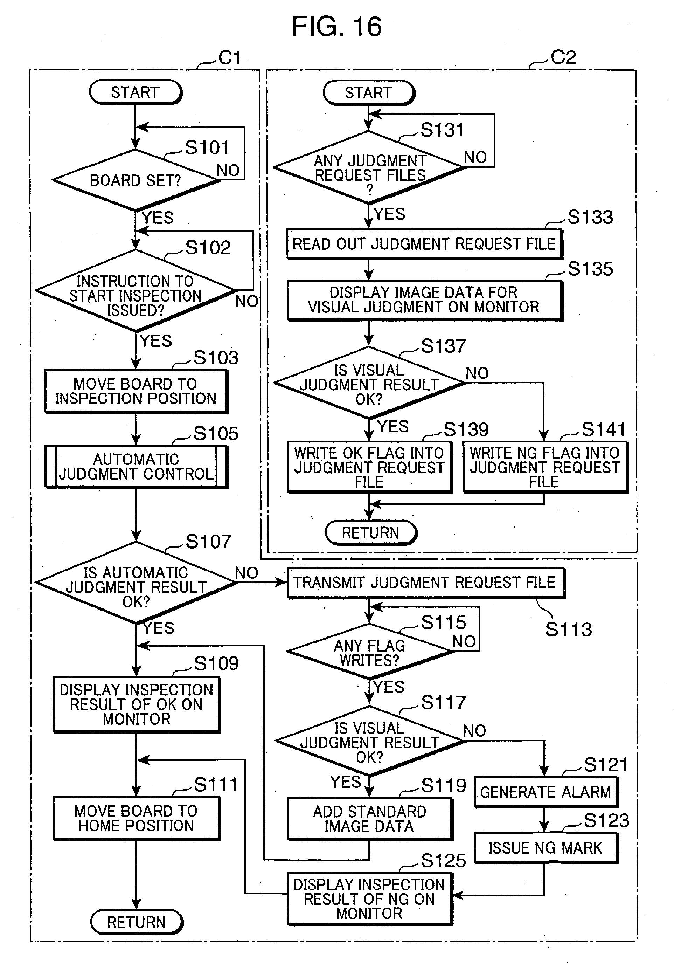

Next, a control operation by the board inspection system 10 configured as described above will be explained with reference to a flowchart shown in Figure 16. As is apparent from Figure 16, in the board inspection system 10, two control flows C1 and C2 proceed concurrently. Among these, the control flow C1 is a control flow used when the master inspection device 1a and the slave inspection devices 1b, 1b, ... respectively perform an automatic judgment on the print board P, and is to be commonly executed by the respective inspection devices 1a, 1b, 1b, .... On the other hand, the control flow C2 is a control flow for having an operator visually judge a board judged to be a poor board by the automatic judgment and is to be executed solely by the master inspection device 1a.

First, the control flow C1 for automatic judgment to be commonly executed by the respective inspection devices 1a, 1b, 1b, ... will be described. Upon the start of the control flow C1, the control unit 60 of each of the inspection devices 1a, 1b, 1b, ... waits for the print board P to be set on the table 30 of the board supplying unit 24 and for instructions to start an inspection to be inputted to the liquid crystal panel 4 (steps S101, S102), and executes control for moving the print board P to the inspection position (step S103). More specifically, upon confirming that the print board P has been set on the table 30 at its home position (refer to the solid line in Figure 3) through the inlet/outlet 6 and that a touch operation has been performed on the liquid crystal panel 4 to select "start inspection" from the menu screen thereof, the single axis robot 20 is activated to move the table 30 in a Y-axis direction and, in response thereto, the print board P is moved to the inspection position indicated by the dashed two-dotted line shown in Figure 4.

Next, the control unit 60 proceeds to step S105 and to automatic judgment control for performing operations such as picking up an image of the print board P and judging whether the print board P is good or poor. Specific contents of the automatic judgment control at this point is similar to the first embodiment. In other words, by picking up an image of the print board P using the camera 52 and comparing the picked-up image with standard image data stored in the image memory unit 50a of the master inspection device 1a to determine a difference, a difference image such as that shown in Figure 8C is extracted and, at the same time, a judgment is made on whether the print board P is good or poor depending on whether an area s of each difference element within the image is equal to or smaller than a predetermined upper limit difference area A or not.

Subsequently, when the print board P is judged to be a good board as a result of automatic judgment control such as described above (YES in step S107), the control unit 60 of the inspection device 1a or 1b which had made the judgment displays information to the effect that the print board P is a good board on the liquid crystal panel 4 of the inspection device 1a or 1b (step S109), and subsequently executes control for restoring the table 30 to its home position at which the print board P can be attached/detached (step S111).

On the other hand, when the print board P is judged to be a poor board as a result of the automatic judgment control (NO in step S107), a control is executed for transmitting a judgment request file consisting of image data for a visual judgment by the operator and the like to the judgment request folder 60b of the master inspection device 1a (step S113). More specifically, a difference image extracted during the automatic judgment control of step S105 is combined with the picked-up image of the print board P picked up during the same control, image data for visual judgment is created by applying predetermined coloring (processing in which difference elements are colored into colors in accordance with difference characteristics) and the like, whereby data obtained by adding information, such as regarding an inspection machine at which the poor board had occurred or the occurrence number (serial number) at the inspection machine, to the image data is transmitted as the judgment request file to the judgment request folder 60b of the master inspection device 1a.

Once the judgment request file is transmitted to the judgment request folder 60b of the master inspection device 1a in this manner, operations shown in the control flow C2 are executed at the master inspection device 1a in order to have the operator perform a visual inspection. In other words, in the control flow C2, the control unit 60 of the master inspection device 1a first confirms whether or not there are judgment request files saved in the judgment request folder 60b (step S131), and if files exist, the saved judgment request files are sequentially read out (step S133), and control is executed for extracting image data for visual inspection from the files and displaying the same on the liquid crystal monitor 4 (step S135). Then, the control unit 60 judges whether the result of a visual judgment performed based on the image displayed on the liquid crystal monitor 4 is a good board or not (step S137). More specifically, a judgment is made on whether or not an operation signal indicating that the judgment result is a good board has been inputted from the liquid crystal panel 4 by a touch operation of the same performed by the operator.

Subsequently, when YES is judged in step S137 to confirm that the result of the visual judgment by the operator is a good board, a control is executed for writing an OK flag indicating that the visual judgment result was a good board onto the processed judgment request file (step S139). Conversely, when NO is judged in step S137 to confirm that the result of the visual judgment by the operator is a poor board, a control is executed for writing an NG flag indicating that the visual judgment result was a poor board onto the judgment request file (step S141). As shown, at the master inspection device 1a, every time the operator performs a visual inspection, a flag indicating whether the result of the visual inspection was good or poor is sequentially written onto judgment request files transmitted from the respective inspection devices 1a, 1b, 1b, ....

Meanwhile, upon returning to the control flow C1, the inspection device 1a or 1b of the side having requested the judgment waits for the flag to be written into the judgment request file (step S115), and the control unit 60 judges whether the result of the visual judgment by the operator was a good board or a poor board by confirming whether an OK flag or an NG flag has been raised as the aforementioned flag (step S117).

Then, when YES is judged in step S117 to confirm that the result of the visual judgment by the operator is a good board, a control is executed for additionally storing a picked-up image of the print board P judged to be a good board in the image memory unit 60a as the standard image data (step S119). Subsequently, the flow returns to step S9 to display information to the effect that the print board P is a good board on the liquid crystal panel 4, and causes the print board P to return to its home position (step S111).

On the other hand, when NO is judged in step S117 to confirm that the result of the visual judgment by the operator is a poor board, a warning alarm is generated (step S121) and, at the same time, a control is executed in which the marking unit 55 is activated to issue an NG mark to the print board P (step S123). Subsequently, after displaying information to the effect that the print board P is a poor board on the liquid crystal panel 4 (step S125), the flow returns to step S111 to cause the print board P to return to its home position.

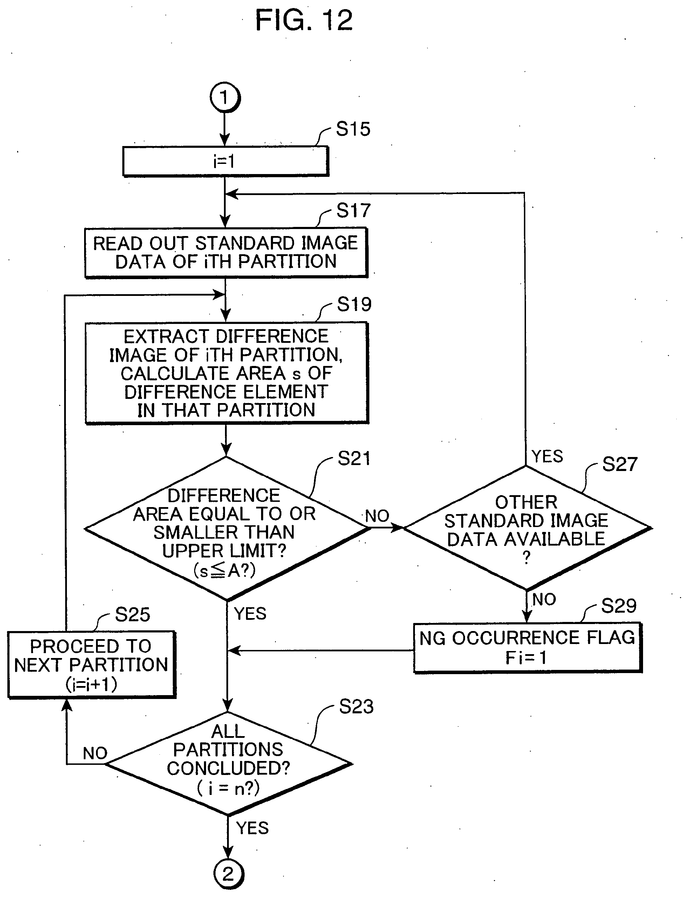

Moreover, in the control operations described above, when performing the automatic judgment control of step S105 per each image pickup area partitioned in advance on the print board P or, in other words, when the automatic judgment control is performed in a manner similar to the flowcharts (Figure 11 or 12) described in the first embodiment by picking up images of the print board P with the camera 52 per each image pickup area partitioned in advance and comparing a difference area s calculated per each image pickup area with an upper limit difference area A, the transmission of a judgment request file is to be executed after waiting for the completion of automatic judgment on all image pickup areas even if the result of an automatic judgment on one or more image pickup areas turns out to be NG in the course of sequentially performing automatic judgment per image pickup area. In addition, in the flowchart C2 to be executed by the master inspection device 1a, image data for visual inspection is sequentially displayed on the liquid crystal monitor 4 in correspondence to the one or more image pickup areas judged as being NG by the automatic judgment, whereby the operator performs visual judgment while sequentially viewing the image data of the image pickup areas judged as being NG. In this case, an NG flag is to be written into the judgment request file when the visual judgment by the operator on any of the image pickup areas results in NG, while an OK flag is to be written into the judgment request file when the visual judgment by the operator on all of the image pickup areas (all image pickup areas whose automatic judgment results had been NG) results in OK.

Furthermore, while control operations of both flowcharts C1 and C2 are to be concurrently executed at the master inspection device 1a, during such time, the liquid crystal monitor 4 is to be suitably utilized for the execution of the respective flowcharts C1 and C2. In other words, between the displaying of image data for visual judgment in step S135 and the inputting of a visual judgment result by the operator in step S137 of the flowchart C2, the liquid crystal monitor 4 is to be used for executing the flowchart C2. On the other hand, until the operator inputs an instruction for commencing an inspection in step S102 or during the display of an inspection result on the monitor in step S109 of the flowchart C1, the liquid crystal monitor 4 is to be used for executing the flowchart C1. To ensure that these time slots do not overlap each other, the master inspection device 1a is arranged such that the display control (control for displaying image data for visual judgment) of the liquid crystal monitor 4 in steps S135 and S137 of the flowchart C2 is preferentially executed over the display control of the liquid crystal monitor 4 in steps S102 and S109 of the flowchart C1.

As described above, according to the second embodiment, in the board inspection system 10 capable of concurrently inspecting a plurality of print boards P by providing a plurality of inspection devices 1a, 1b, 1b, ... (the master inspection device 1a and the slave inspection devices 1b, 1b, ...), by arranging images of a print board P judged to be a poor board by any of the inspection devices 1a, 1b, 1b, ... to be intensively displayed on the liquid crystal monitor 4 of a common master inspection device 1a comprising one of the respective inspection devices 1a, 1b, 1b, ..., the operator can now visually judge a board while constantly viewing the liquid crystal monitor 4 of the same master inspection device 1a regardless of whether a poor board has occurred at any of the inspection devices 1a, 1b, 1b, ..., and upon the occurrence of a poor board, the operator is no longer required to move to the inspection machine corresponding to the print board P to perform a visual judgment. As a result, a plurality of print boards P can now be concurrently inspected and a board inspection system 10 with greater workability may be achieved.

Moreover, as is the case with the second embodiment, when the image memory unit 60a is only provided at the master inspection device 1a among the plurality of inspection devices 1a, 1b, 1b, ... and standard image data shared among the respective inspection devices 1a, 1b, 1b, ... are collectively stored in the image memory unit 60a, since it is now possible to judge whether print boards P to be inspected at the respective inspection devices 1a, 1b , 1b , ... are good or poor based on common standard image data, an advantage may be achieved in that variations in judgment standards among the respective inspection devices 1a, 1b, 1b, ... can be prevented and inspections on print boards P can be performed efficiently.

While the control unit 60 has been separately provided at each of the inspection devices 1a, 1b, 1b, ..... in the second embodiment, for example, a centralized control unit that integrally controls operations of all inspection devices 1a, 1b, 1b, ... may alternatively be provided at the master inspection device 1a among the inspection devices 1a, 1b, 1b, ....

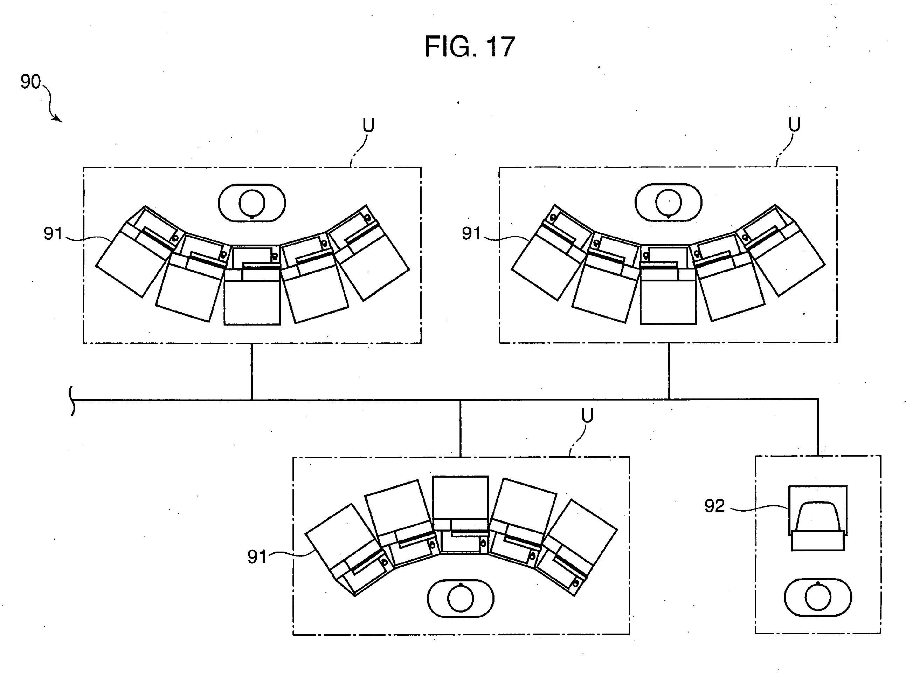

In addition, while the second embodiment has been arranged so as to save space occupied by the inspection system 10 and the like by providing the master inspection device 1a that is one of a plurality of inspection devices 1a, 1b, 1b, ... with a function as a visual judgment machine which the operator uses to visually judge a print board P, it is obvious that the visual judgment machine can be exclusively provided separate from the inspection machines. Figure 17 shows an example of such a mode of use. With a board inspection system 90 in the example shown in Figure 17, a plurality of board inspection units U formed by aligning a plurality of inspection devices 91 for performing board inspections is provided, whereby the plurality of board inspection units U is respectively connected to a visual judgment machine 92 via a network line. Moreover, in this configuration, each of the board inspection units U and the visual judgment machine 92 are respectively operated by an operator. In such a configuration, by having the visual judgment machine 92 collectively store standard image data that is a standard of a good board and having the respective board inspection units U judge whether a print board P is good or poor using the standard image data stored in the visual judgment machine 92 as a standard, an advantage may be achieved in that judgment standards of good/poor judgment at all board inspection units U can be set to a certain level and the quality of the print board P can be further stabilized. Furthermore, since an operator to perform a visual judgment is always the same operator, an advantage may be achieved in that the judgment standards of visual judgments become constant and occurrences of significant variations in standard image data to be added during the course of inspection can be effectively avoided.

While the first and second embodiments described above have been arranged such that, when a print board P is judged to be a poor board by an automatic judgment by the control unit 60, an image combining a picked-up image of the print board P and a difference image extracted through predetermined image processing is to be displayed on the liquid crystal monitor 4 as an image for a visual judgment by the operator, a reference image that may be of some reference during the visual judgment may be displayed as another image together with the aforementioned image in the vicinity thereof. Next, a specific example of a case that adopts the above-mentioned configuration will be described based on a third embodiment presented below.

### <Third Embodiment>

It is assumed that an inspection device having a similar structure to the inspection device 1 according to the first embodiment is used in the present third embodiment, and a specific structure thereof is as shown in Figures 1 to 7. However, the inspection device according to the present third embodiment (hereinafter referred to as the inspection device 1) differs from the first embodiment in the mode of images displayed on a liquid crystal monitor 4 for a visual judgment by an operator. As such, a description will be given below focusing on this point.

With the inspection device 1 according to the present embodiment, after an appearance inspection of a print board P is performed by a control unit 60, a picked-up image of a portion judged to be poor by the control unit 60 is displayed on a liquid crystal monitor 4 and a visual judgment by an operator is performed. The poor portion displayed on the liquid crystal monitor 4 displays a difference image between an image of the poor portion and a standard image. In this case, standard image data that is image data of a standard image according to the present embodiment is configured so as to include six types of boundary image data, and a standard image based on the standard image data is to be created by the control unit 60. More specifically, the six types of boundary images based on the six type of boundary image data are: a right-side displacement boundary image, a left-side displacement boundary image, an upper-side displacement boundary image, a lower-side displacement boundary image, an area large boundary image, and an area small boundary image.

A displacement boundary image refers to an image showing a good board-state immediately prior to an inspection object being judged to be poor due to a displacement of the inspection object with respect to a normal position on a print board P and, for example, a right-side displacement boundary image refers to a displacement boundary image in the case where an inspection object is positionally displaced to the right side with respect to a normal position on a print board P. In addition, an area large boundary image refers to an image showing a good board-state immediately prior to an inspection object being judged to be poor due to the area of the inspection object being larger than a predetermined area on a print board P, while an area small boundary image refers to an image showing a good board-state immediately prior to an inspection object being judged to be poor due to the area of the inspection object being smaller than a predetermined area on a print board P.

A method of creating a visual judgment difference image will now be described. When an image of the face of the print board P subjected to inspection is picked up by the camera 52, the control unit 60 first performs processing for comparing image data of the picked-up image of the print board P with standard image data to be used as a standard for judging whether the state of the print board P is good or poor. More specifically, the control unit 60, having stored the standard image data in an internally provided memory unit 61 (Figure 7), compares the standard image data with image data of the image of the print board P picked up by the camera 52 to determine a difference, and creates a difference image based on the difference. Creation of the difference image is executed in a state where, for example, fiducial marks for position alignment which are provided spaced at a plurality of locations on a mounted face of the print board P are matched between image data of the picked-up image of the print board P and the standard image data in order to align the positions of both images.

### <Display modes of the liquid crystal monitor 4>

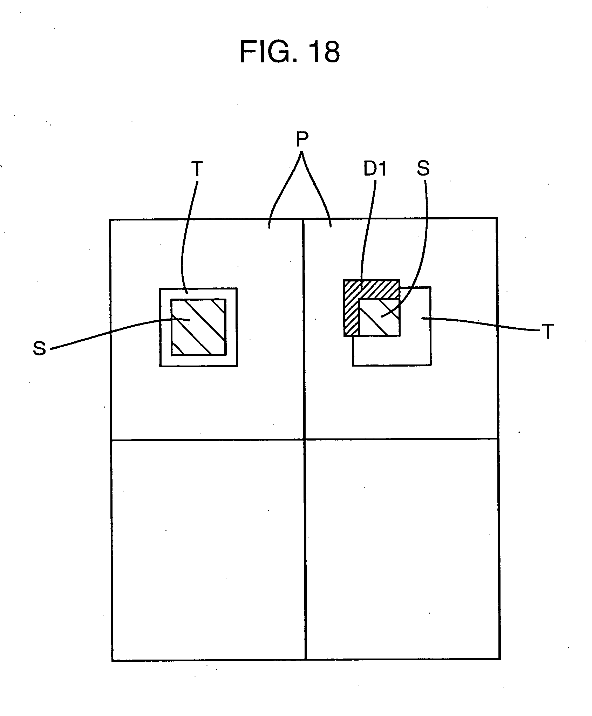

Next, a specific display method for concurrently displaying the difference image displayed on the liquid crystal monitor 4 and a reference image that can be referenced during a visual judgment will be described. Note that, in the present embodiment, the appearance inspection object is a printed board on which a cream solder (hereinafter simply referred to as solder) is printed. Figures 18 to 21 represent display screens on the liquid crystal monitor 4, and respectively show four representative display patterns. Difference areas D1 and D2 in the difference image are colored and displayed in colors that differ from those of other areas, making it possible to clearly distinguish the difference areas D1 and D2 from areas other than the difference areas D1 and D2. The display screen of the liquid crystal monitor 4 is divided into four areas by bisecting the display screen in both the vertical and horizontal directions. Hereinafter, a description will be given on an example of a positional displacement fault in which a cream solder S has been printed displaced with respect to an edge portion (land) T of a square formed on the print board P.

Display pattern 1 (Figure 18) is a pattern in which a normal image (an image of a normal state of the print board P or, in other words, a state in which the solder S is printed at an ideal printing position on the print board P) is displayed as one of such reference images in the upper-left area, while the difference image and a picked-up image of the print board P are displayed superimposed on one another in the upper-right area. The difference area D1 of the difference image based on a difference between the picked-up image and the normal image of the print board P is displayed in an area ranging from a left-side portion to an upper-side portion of the display area of the solder S in the picked-up image of the print board P.

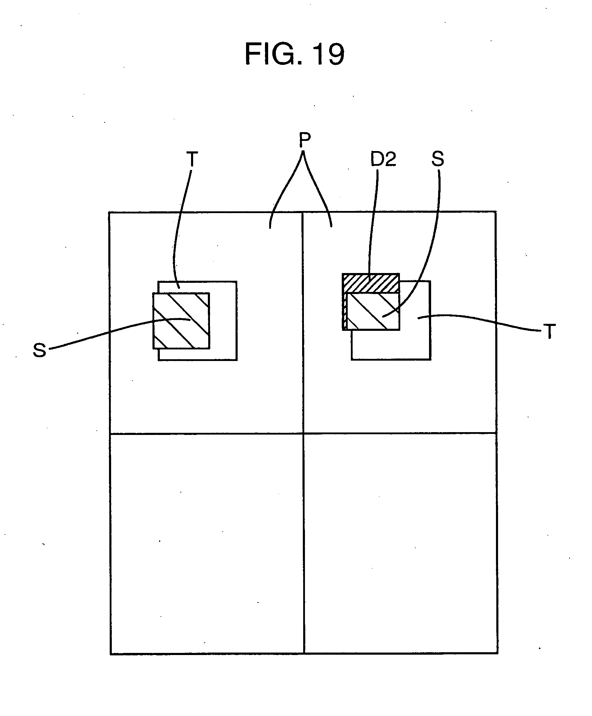

Display pattern 2 (Figure 19) is a pattern in which a left-side displacement boundary image (an image showing a good board boundary in a case where the solder S is printed displaced to the left side with respect to a predetermined printing position on the print board P) is displayed as a reference image in the upper-left area, while the difference image and a picked-up image of the print board P are displayed superimposed on one another in the upper-right area. The difference area D2 of the difference image based on a difference between the picked-up image and the left-side displacement boundary image of the print board P is displayed in an area ranging from a left-side portion to an upper-side portion of the display area of the solder S in the picked-up image of the print board P. The area of the left-side portion of the difference area D2 is smaller than the area of the left-side portion of the difference area D1 shown in Figure 18.

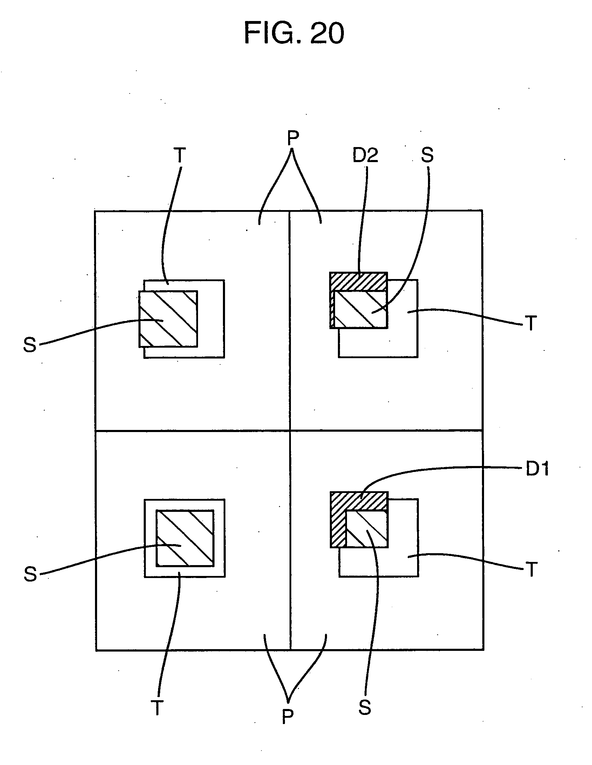

Display pattern 3 (Figure 20) is a pattern in which: a left-side displacement boundary image is displayed as a reference image in the upper-left area; the difference image (difference area D2) and a picked-up image of the print board P are displayed superimposed on one another in the upper-right area; the normal image is displayed in the lower-left area; and the difference image (difference area D1) and a picked-up image of the print board P are displayed superimposed on one another in the lower-right area.

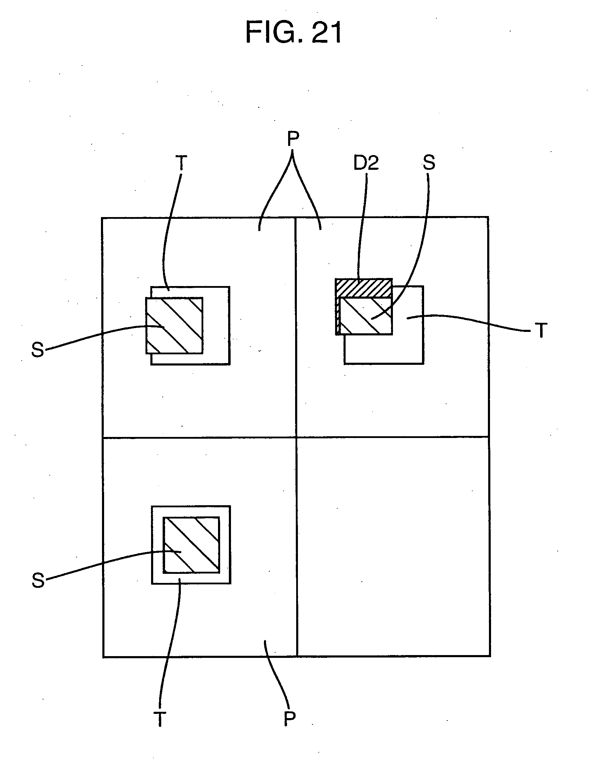

Display pattern 4 (Figure 21) is a pattern in which: a left-side displacement boundary image is displayed as a reference image in the upper-left area; the difference image (difference area D2) and a picked-up image of the print board P are displayed superimposed on one another in the upper-right area; and the normal image is displayed as a reference image in the lower-left area. Among the four display patterns described above, a display pattern suitable for visual judgment can be appropriately selected at the operator's own discretion from the display patterns 1 to 4. Moreover, in the display patterns 1 to 4, a superposition of a difference image (difference area D2) and the left-side displacement boundary image or a superposition of a difference image (difference area D1) and the normal image may be displayed as a reference image.

### <Procedure for creating a boundary image>

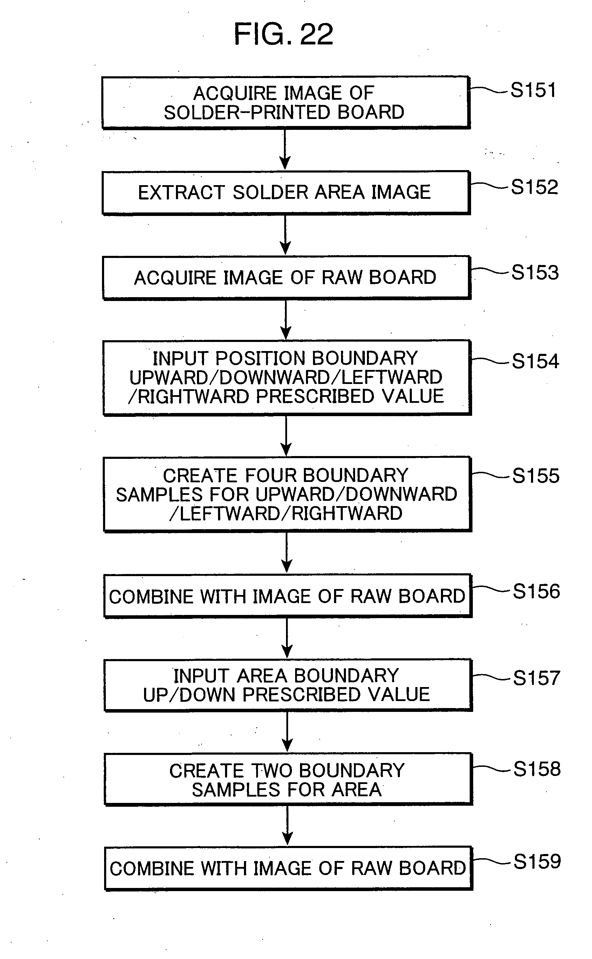

Next, a procedure for creating six types of boundary images corresponding to positional displacement faults (the four types of up, down, left and right) and large/small area faults (the two types of large and small) by image processor will be described with reference to Figure 22. A positional displacement fault refers to a fault in which a solder S is printed at a position displaced from a predetermined printing position on the print board P. In addition, "area large/small faults" is an abbreviated expression for an area large fault and an area small fault. An area large fault refers to a fault in which the area of a solder S printed on the print board P is larger than a predetermined area, while an area small fault refers to a fault in which the area of the solder S printed on the print board P is smaller than the predetermined area.

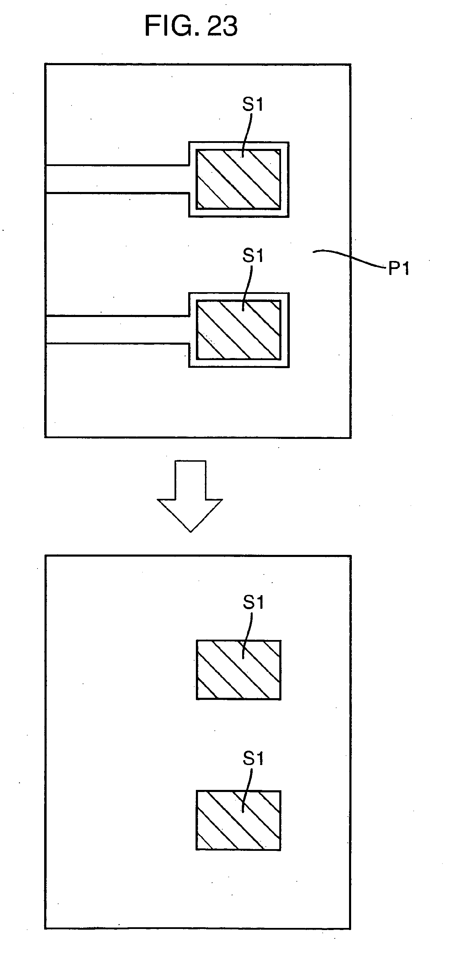

First, an image of a board (hereinafter referred to as solder-printed board P2) on which an inspection object (hereinafter referred to as solder S1) is placed on its normal position is picked up by image pickup device (hereinafter referred to as camera 52), and as shown in the upper half of Figure 23, a picked-up image of the solder-printed board P2 is acquired (S151). Image data of a solder S1 area image is extracted from image data of the picked-up image of the solder-printed board P2 (S152), and as shown in the lower half of Figure 23, a solder S1 area image is created based on image data of the solder S1 area image. Next, an image of a board P1 on which a solder S1 has not been printed (hereinafter referred to as a raw board) is picked up by the camera 52, and a picked-up image of the raw board P1 is acquired (S153).

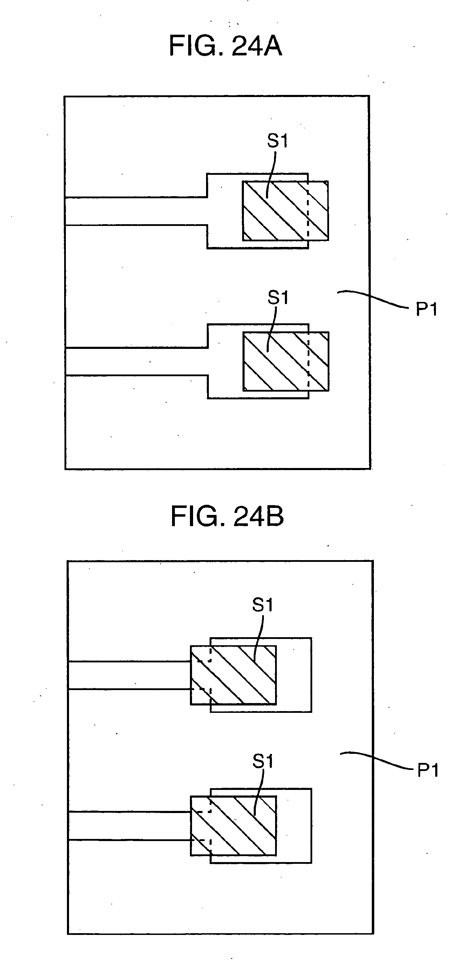

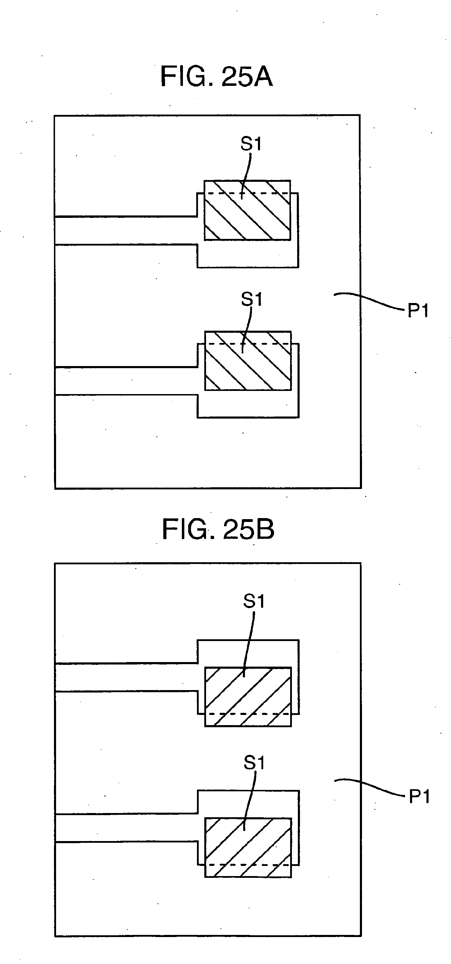

The operator then inputs a predetermined displacement allowance with respect to a normal printing position (hereinafter referred to as a position boundary upward/downward/leftward/rightward prescribed value) via input device such as a numerical keypad (S154), and causes the inputted position boundary upward/downward/leftward/rightward prescribed value to be stored in memory (hereinafter referred to as memory unit 61). In response thereto, image data of the solder S1 area image is moved in a predetermined direction (upward/downward/leftward/rightward) based on the position boundary upward/downward/leftward/rightward prescribed value stored in the memory unit 61 and boundary image data of the solder S1 area image is created (S155). Subsequently, boundary image data (hereinafter referred to as positional displacement boundary image data) L1 is created by combining boundary image data of the solder area S1 image and image data of the picked-up image of the raw board P1 (S156), and a positional displacement boundary image is created based on the positional displacement boundary image data L1. In this manner, the right-side displacement boundary image shown in Figure 24A, the left-side displacement boundary image shown in Figure 24B, the upper-side displacement boundary image shown in Figure 25A, and the lower-side displacement boundary image shown in Figure 25B are created.

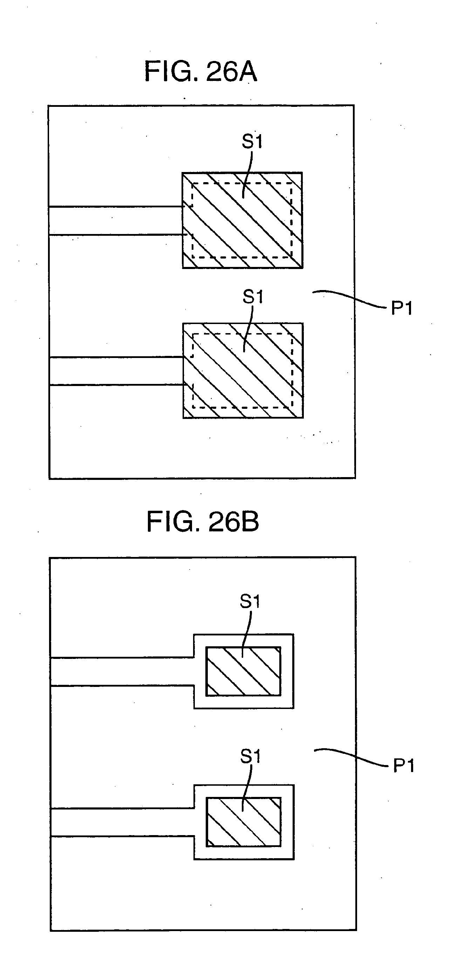

In addition, the operator inputs a predetermined variable ratio with respect to a normal printing area (hereinafter referred to as an area boundary up/down prescribed value) via input device such as a numerical keypad (S157), and causes the inputted area boundary up/down prescribed value to be stored in the memory unit 61. In response thereto, boundary image data of the solder S1 area image is created by having the image data of the solder S1 area image expanded or reduced based on the area boundary up/down prescribed value stored in the memory unit 61 (S158). Subsequently, area large/small boundary image data L2 is created by combining boundary image data of the solder S1 area image and image data of the picked-up image of the raw board P1 (S159), and an area large/small boundary image is created based on the area large/small boundary image data L2. In this manner, the area large boundary image shown in Figure 26A and the area small boundary image shown in Figure 26B are created.

Image creating software for creating the various boundary images described above can be configured so as to comprise: an image pickup step for picking up an image of a board on which an inspection object has been placed and an image of a board on which the inspection object has not been placed using image pickup device; a storing step for storing a predetermined value inputted via input device; an extracting step for extracting image data of the inspection object by comparing image data of the picked-up image of the board on which the inspection object obtained in the image pickup step has been placed with image data of the picked-up image of the board on which the inspection object obtained in the image pickup step has not been placed in order to determine a difference; a varying step for creating variable image data of the inspection object by varying image data of the inspection object obtained in the extracting step based on the predetermined value stored in the storing step; a composite step for creating boundary image data by combining variable image data of the inspection object obtained in the varying step with image data of the picked-up image of the board on which the inspection object has not been placed; and an image creating step for creating a boundary image using image processor based on the boundary image data obtained in the composite step.

### <Operation for displaying images during inspection>

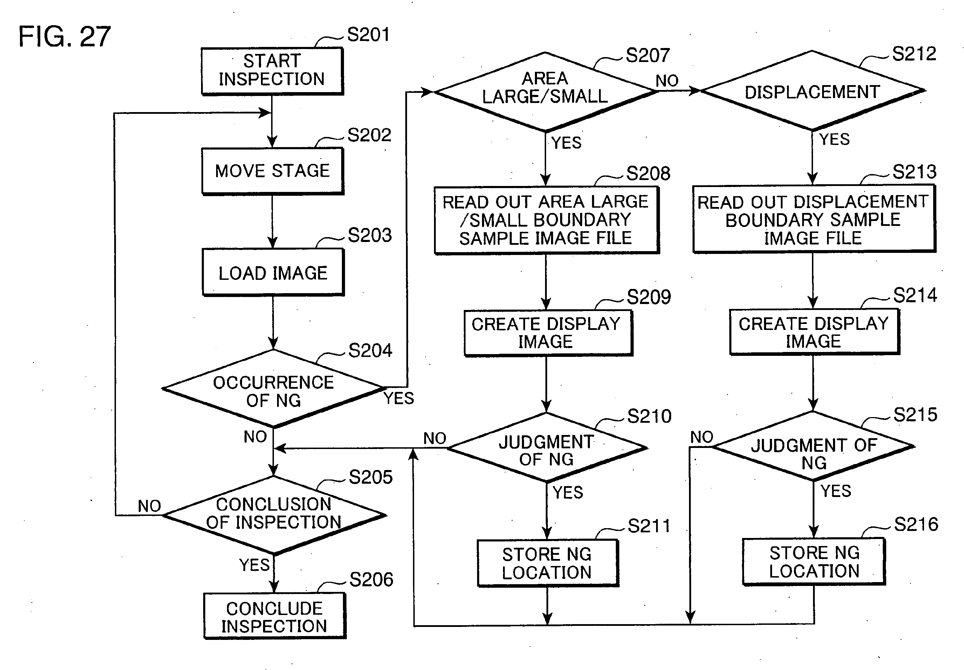

Next, a control operation by the control unit 60 in the inspection device 1 configured as described above will be explained with reference to the flowchart shown in Figure 27. When the print board P has been set on a table 30 at its home position (refer to the solid line in Figure 3) through an inlet/outlet 6 and a touch operation has been performed on the liquid crystal panel 4 to select "start inspection" from the menu screen thereof (S201), a single axis robot 20 is activated to move the table 30 in a Y-axis direction and, in response thereto, the print board P is moved to the inspection position indicated by the dashed two-dotted line shown in Figure 3 (S202). Subsequently, a single axis robot 40 is activated to align the position of an image pickup unit 51 above the print board P that is at the inspection position and an illuminating light is irradiated by an illuminating device 54 to illuminate the print board P. In this state, a control signal is outputted to the camera 52 to pick up an image of the print board P and a picked-up image of the print board P is acquired (S203).

The control unit 60 then reads out boundary image data from the memory unit 61 and compares the standard image data with the picked-up image of the print board P to determine a difference, and calculates an area s of a difference element. Then, a judgment is made on whether the area s is equal to or below an upper limit difference area A stored in the memory unit 61. When the area s is equal to or smaller than the upper limit area A, it is judged that no faults have occurred (S204) and the table 30 is moved from the inspection position to the home position. Subsequently, "end inspection" and "start inspection" are displayed on the liquid crystal monitor 4. When "end inspection" is selected (S205), the inspection is concluded (S206). Alternatively, when "start inspection" is selected (S205), the flow proceeds to S202 to perform a next inspection.

On the other hand, when the area s is larger than the upper limit area A, it is judged that a fault has occurred (S204) and a judgment is made on whether the occurred fault is an area large/small fault or not. In the case the fault is an area large/small fault (S207), area large/small fault boundary image data is read out from the memory unit 61 (S208), the area large/small boundary image data is compared with image data of the picked-up image of the print board P to determine a difference, and a difference image based on the difference is created (S209). The difference image is displayed on the liquid crystal monitor 4, whereby a visual judgment is performed by an operator. At the same time, "NG judgment" and "OK judgment" are displayed on the liquid crystal monitor 4. When a fault is confirmed as a result of the visual judgment and "NG judgment" is selected (S210), positional data of the portion at which the fault had occurred is stored in the memory unit 61 (S211), the table 30 is moved from the inspection position to the home position, and the flow proceeds to S205 to judge whether the inspection has been concluded or not.

When an absence of a fault is confirmed as a result of the visual judgment by an operator and "OK judgment" is selected (S210), the table 30 is moved from the inspection position to the home position, and the flow proceeds to S205 to judge whether the inspection has been concluded or not.

On the other hand, when it is judged that the occurred fault is not an area large/small fault (S207), a judgment is made on whether the fault is a positional displacement fault or not. In the case the fault is a positional displacement fault (S212), positional displacement fault boundary image data is read out from the memory unit 61 (S213), the positional displacement fault boundary image data is compared with image data of the picked-up image of the print board P to determine a difference, and a difference image based on the difference is created (S214). The difference image is displayed on the liquid crystal monitor 4, whereby a visual judgment is performed by an operator. At the same time, "NG judgment" and "OK judgment" are displayed on the liquid crystal monitor 4. When a fault is confirmed as a result of the visual judgment and "NG judgment" is selected (S215), positional data of the portion at which the fault had occurred is stored in the memory unit 61 (S216), the table 30 is moved from the inspection position to the home position, and the flow proceeds to S205 to judge whether the inspection has been concluded or not.

Alternatively, when an absence of a fault is confirmed as a result of the visual judgment by an operator and "OK judgment" is selected (S215), the table 30 is moved from the inspection position to the home position, and the flow proceeds to S205 to judge whether the inspection has been concluded or not.

As described above, the present embodiment is capable of achieving the following advantages.

1. By displaying a difference image between a picked-up image of a print board P picked up by the camera 52 and a boundary image on the liquid crystal monitor 4, and concurrently displaying the boundary image as a reference image, the difference between the picked-up image of the print board P and the boundary image can be highlighted. Therefore, the accuracy of good/poor judgment can be stabilized and, at the same time, the efficiency of an inspection through a visual judgment by an operator can be improved.
2. By combining difference image data with picked-up image data of the print board P in a positioned state and displaying the data superimposed on each other, a good/poor judgment can be performed while taking specific circumstances of the print board P into consideration. For example, even in cases where a plurality of terminal portions T is placed in proximity to each other on the print board P and, due to the short distances between adjacent terminal portions T, a fault is judged upon the occurrence of a positional displacement in the alignment direction of the terminal portions T, there may be cases where a fault will not be judged when a positional displacement occurs in a direction perpendicular to the alignment direction of the terminal portions T even if the areas of difference images are the same.
3. A normal image as a reference image can be compared with an image combining a difference image based on the normal image and a picked-up image of a print board P (display pattern 1).
4. A boundary image as a reference image can be compared with an image combining a difference image based on the boundary image and a picked-up image of a print board P (display pattern 2).
5. A boundary image as a reference image can be compared with: an image combining a difference image based on the boundary image and a picked-up image of a print board P; a normal image as a reference image; and an image combining a difference image based on the normal image and the picked-up image of the print board P (display pattern 3).
6. A boundary image as a reference image can be compared with: an image combining a difference image based on the boundary image and a picked-up image of a print board P; and a normal image as a reference image (display pattern 4).
7. A boundary image suitable for creating a difference image can be appropriately selected from six types of boundary images corresponding to fault contents.
8. By performing a visual judgment only on a portion judged to be a fault in an automatic judgment step, the period of time required for inspection can be reduced in comparison with performing visual judgments on all portions.
9. Since the display area of a difference image is colored and displayed in a color that differs from display areas other than the difference image, the difference image becomes more visible.

### <Fourth Embodiment>

### <Overall configuration>

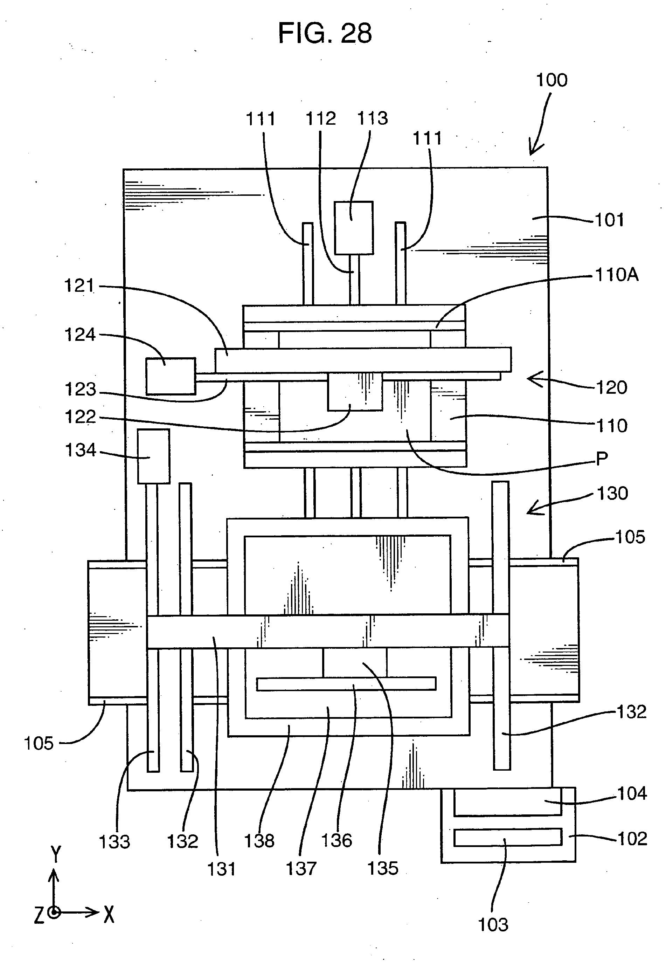

Figure 28 is a plan view showing a cream solder printing machine 100 according to a fourth embodiment of the present invention. As shown in the drawing, the cream solder printing machine 100 comprises: a printing unit 130 which prints printing material such as a cream solder at a predetermined position on a print board P; an inspection unit 120 which inspects the printed state of the cream solder printed by the printing unit 130; and a board printing table 110 which causes a reciprocating movement between a printing area where the printing unit 130 is positioned and an inspection area where the inspection unit 120 is positioned in a state where the print board P on which the cream solder has been printed is mounted. In addition, an upstream side and a downstream side contiguous to the printing unit 130 are provided with a pair of board-carrying conveyors 105 for conveying the print board P into and out from the printing area.

The printing unit 130 is placed on a front side (the lower side in the drawing) on a base 101, while the inspection unit 120 is placed behind the printing unit 130. A work table 102 is fixed to the base 101 on the front side of the printing unit 130. A keyboard 103 as input device and an image display device 104 according to the present invention are provided on the work table 102. An operator can input various prescribed values (such as an upper limit area A with respect to an area s of a difference element) using the keyboard 103 to visually perform an appearance inspection while viewing a difference image and a reference image concurrently displayed on the image display device 104.

### <Configuration of printing unit 130>

A mask 137 drilled with an opening having a predetermined mask pattern is held by a mask supporting frame 138 above the board-moving table 110 in the printing area and the board-carrying conveyor 105. The mask supporting frame 138 is fixed on an upper portion of a frame, not shown, integrated with the base 101. By supplying a cream solder onto the mask 137 from a nozzle, not shown, and scraping the supplied cream solder with a squeegee 136 and filling the opening of the mask 137 with the cream solder, the cream solder can be printed at a predetermined position on the print board P.

The printing unit 130 which moves the squeegee 136 in a Y-direction while causing the same to slidingly contact the mask 137 is configured so as to comprise: a squeegee unit 135 which raises/lowers and holds the squeegee 136; a squeegee unit supporting member 131 which extends in an X-direction and which supports the squeegee unit 135; and a pair of Y-direction guide rails 132 which support the squeegee unit supporting member 131 so as to be movable in a Y-direction.

Both Y-direction guide rails 132 are fixed on an upper portion of a frame, not shown, integrated with the base 101. A Y-direction ball threaded shaft 133 which fits into a ball nut fixed to the squeegee unit supporting member 131 is fixed lateral to the Y-direction guide rail 132 on the left side in the drawing so as to be axially rotational. A servomotor 134 which rotationally drives the Y-direction ball threaded shaft 133 is provided on an end of the Y-direction ball threaded shaft 133. The servomotor 134 is fixed to an upper portion of a frame, not shown, integrated with the base 101. Accordingly, the squeegee unit supporting member 131 is moved in the Y-direction due to rotational driving by the servomotor 134.

### <Configuration of board-moving table 110>

The board-moving table 110 is constituted by an upper member and a lower member. The upper member is movable in X, Y, Z, and R directions within respective predetermined ranges with respect to the lower member. Accordingly, due to the driving of the upper member of the board-moving table 110 in a Z-direction, a print board P mounted on the upper member is moved in the Z-direction between an abutting position at which the print board P abuts a lower face of the mask 137 and a spaced position at which the print board P is spaced from the lower face of the mask 137.

In addition, a board-carrying conveyor 110A mobilized when conveying the print board P in and out is provided on the upper member of the board-moving table 110. When the upper member of the board-moving table 110 becomes consistent with and links to the board-carrying conveyor 105 in the Y and Z directions and a state is reached in which the print board P prior to printing becomes deliverable/receivable, the board-carrying conveyor 110A conveys and holds the print board P conveyed by the upstream-side board-carrying conveyor 105 to a predetermined position on the upper member of the board-moving table 110. In addition, when the deliverable/receivable state is reached after printing or after inspection, the board-carrying conveyor 110A conveys the printed or inspected print board P held at a predetermined position on the upper member of the board-moving table 110 to the downstream-side board-carrying conveyor 105.

A pair of Y-direction rails 111 which support the lower member of the board-moving table 110 so as to be movable in a Y-direction is fixed on the base 101. A Y-direction ball threaded shaft 112 which fits into a ball nut, not shown, fixed to the lower member of the board-moving table 110 is fixed between both Y-direction rails 111 on the base 101 so as to be axially rotational. A servomotor 113 which rotationally drives the Y-direction ball threaded shaft 112 is provided on an end of the Y-direction ball threaded shaft 112. Accordingly, the board-moving table 110 can be moved to a desired position in the Y-direction due to rotational driving of the servomotor 113.

### <Configuration of inspection unit 120>

The inspection unit 120 extends in an X-direction, and comprises: a supporting member 121 whose both ends are fixed to the base 101; and an image pickup device 122 supported by the supporting member 121 so as to be movable in the X-direction. An X-direction ball threaded shaft 123 which fits into a ball nut, not shown, fixed to the image pickup device 122 is fixed to the supporting member 121 so as to be axially rotational. A servomotor 124 which rotationally drives the X-direction ball threaded shaft 123 is provided on an end of the X-direction ball threaded shaft 123. The servomotor 124 is fixed to a frame, not shown, integrated with the base 101. Accordingly, the image pickup device 122 can be moved to a desired position in the X-direction due to rotational driving of the servomotor 124.

### <Operations of cream solder printing machine 100>

First, a print board P is conveyed from the upstream side to a desired position on the upper member of the board table 110 by the board-carrying conveyors 105 and 110A. As the print board P is held on the board-carrying conveyor 110A, an image of a fiducial mark on the print board P is picked up by a first camera, not shown, while an image of a position alignment mark of the mask 137 is picked up by a second camera, not shown. Due to the movement of the upper member of the board table 110 in the X-direction, the Y-direction or, further, in the R-axis direction with respect to the lower member, the fiducial mark and the position alignment mark are positionally compensated so as to become consistent. Furthermore, in a positionally compensated state, the upper member of the board table 110 rises in the Z-direction from the spaced position to the abutting position, thereby causing the print board P to abut the lower face of the mask 137. As a result, the squeegee 136 is lowered in the Z-direction by the squeegee unit 135 to abut the mask 137, the squeegee unit supporting member 131 and the squeegee 136 are combined and moved in the Y-direction due to the rotational driving of the servomotor 134, and a cream solder is passed through the opening of the mask 137 to be printed on the print board P. Once printing is concluded, the squeegee 136 rises, the upper member of the board table 110 descends from the abutting position to the spaced position, and further moves in the X-direction, the Y-direction or, further, in the R-axis direction to be returned to its state prior to positional compensation.

Next, the board table 110 is moved to the inspection area due to the rotational driving of the servomotor 113. The image pickup device 122 first picks up an image of a fiducial mark on the print board P, while a coordinate system on the print board P is recognized by a control device. The servomotor 113 and the servomotor 124 are rotationally driven so as to position the image pickup device 122 at predetermined X and Y coordinates on the print board P. As image pickup by the image pickup device 122 proceeds, an automatic judgment is performed on whether the printing state of the cream solder printed on the print board P is good or poor. After the automatic judgment is concluded without being issued a fault judgment therein, rotational driving of the servomotor 113 moves the board-carrying conveyor 110A of the board table 110 in the Y-direction until reaching a position matching the board-carrying conveyor 105 in the printing area, and subsequently conveys the board-carrying conveyor 110A to the downstream side. When a fault judgment is made during the automatic judgment, the board table 110 starts to move in the Y-direction after judgments on all locations have been concluded, and a difference image and a reference image are concurrently displayed on the image display device 104 so as to allow a visual appearance inspection by the operator. When the visual inspection also yields a fault judgment, the print board P can now be removed from the board table 110.

As shown, in the present embodiment, since the cream solder printing machine 100 is provided with an image display device 104, an automatic judgment can be performed on a printing state immediately following printing by the printing unit 130, and when the automatic judgment results in a fault judgment, a difference image and a reference image can be concurrently displayed on the image display device 104. Consequently, the period of time required for a visual appearance inspection by the operator may be reduced and, therefore, the takt time for the cream solder printing step can be shortened.

### <Other embodiments>

The present invention is not limited to the embodiments presented in the above descriptions and drawings. For example, embodiments such as described below are also included in the technical scope of the present invention.

(1) While the present embodiment exemplifies a configuration in which a picked-up image of a print board P and a difference image are superimposed on each other and displayed in the same display area of a liquid crystal monitor 4, according to the present invention, the picked-up image of the print board P and the difference image may alternatively be displayed in display areas that differ from each other.

(2) While the present embodiment exemplifies, in Figures 19 to 21, a configuration in which a left-side displacement boundary image is displayed on the liquid crystal monitor 4 as a standard image, according to the present invention, boundary images to be displayed on the liquid crystal monitor 4 are not limited to just one type and a plurality of boundary images may alternatively be displayed side-by-side on the liquid crystal monitor 4. For example, while a normal image is displayed in the lower-left display area and a difference image (difference area D1) and a picked-up image of a print board P are displayed superimposed on one another in the lower-right display area in the third display pattern (Figure 20), according to the present invention, an upper-side displacement boundary image may be displayed in the lower-left display area and a difference image based on the upper-side displacement boundary image and a picked-up image of the print board P may be displayed superimposed on one another in the lower-right display area.

(3) While the present embodiment describes an application example of a case where a solder S is printed on a terminal portion T on the print board P, the present invention is also applicable on a case where an electronic part is placed on the terminal portion T on which the solder S has been printed.

(4) While the present embodiment exemplifies a configuration in which a difference area is colored and displayed in a color that differs from the colors of areas other than the difference area, according to the present invention, a difference area may be displayed uncolored and may alternatively be identified by, for example, enclosing the difference area by a dashed line or hatching the same with diagonal parallel lines or the like.

(5) While the present embodiment exemplifies a configuration in which the display area of the liquid crystal monitor 4 is divided into and displayed as four sections, according to the present invention, the display area may alternatively be divided in accordance with the number of images to be displayed and, for example, the display area of the liquid crystal monitor 4 may be divided into and displayed as two sections for the first display pattern (Figure 18).

(6) While the present embodiment exemplifies upward/downward/leftward/rightward positional displacement faults and area large/small faults as modes of faults, according to the present invention, other faults shall suffice. For example, a wrong solder fault (a fault occurring when a solder of a different type from a solder of a normal type is printed) may be used instead. When such a wrong solder fault occurs, the printing of a solder of a different type may be arranged to be detected using different solder colors.

In conclusion, configurations of the present invention disclosed based on the respective embodiments presented above, as well as advantages thereof, will be summarized and described.

The present invention is a method for carrying out an appearance inspection of a board, comprising: an image pickup step for picking up an image of the board using image pickup device; an automatic judgment step for comparing a picked-up image of the board obtained in the image pickup step with standard image data stored in advance in memory as a standard of a good board to judge whether the board is good or poor; and a visual judgment step for displaying an image of the board on display when the board is judged to be poor in the automatic judgment step to have an operator perform a visual judgment so as to judge whether the board is good or poor based on the image displayed on the display, wherein when the board is judged to be good in the visual judgment step, a picked-up image of the board judged to be good is additionally stored in the memory as the standard image data.

According to the present invention, since the an automatic judgment device judges whether the board is good or poor based on a comparison between the picked-up image of the board picked up by the image pickup device and the standard image data stored in the memory, and when the board is judged to be a poor board, a visual judgment of the board is further performed by the operator, while when the board is judged to be a good board as a result of the visual judgment, the picked-up image of the board judged to be a good board is additionally stored as the standard image data in the memory, results of visual judgments by the operator can be sequentially reflected on the standard image data as the inspection progresses, thereby enabling automatic judgment by the an automatic judgment device based on standard image data of an appropriate range obtained accordingly to be performed with more appropriate accuracy and higher efficiency. In addition, since the range of the standard image data can be made more appropriate by a simple structure of sequentially additionally storing images of a board judged to be a good board by a visual judgment by the operator in the memory, unlike the method described in Patent Document 1 presented earlier which requires complicated program processing to be performed, advantages such as cost reduction, reduction in processing time, or the like may be achieved.

The automatic judgment step is preferably a step in which a picked-up image of the board and standard image data are compared to determine a difference, and whether the board is good or poor is judged based on the difference image.

Accordingly, with a simple structure of determining a difference between two types of images, an advantage may be achieved in that a judgment of whether a board is good or poor can be performed efficiently.

Furthermore, the automatic judgment step is preferably a step in which a picked-up image of each of a plurality of partitions obtained by dividing a picked-up image of the board into a plurality of partitions is compared with standard image data similarly stored for each partition to determine a difference, and whether the board is good or poor is judged based on the extracted difference image of each partition.

As shown, when a picked-up image of a board and standard image data are respectively divided into a plurality of partitions and a judgment on whether the board is good or poor is performed by extracting a difference image for each partition, an advantage may be achieved in that whether the board is good or poor can be judged with an appropriate accuracy in accordance with the size of the inspection object or the like.

In the visual judgment step, while a difference image obtained by comparing a picked-up image of the board with standard image data is to be displayed on display, the difference image to be displayed on the display is preferably a difference image colored in a different color in accordance with difference characteristics.

Accordingly, advantages are achieved in that the visibility during the visual judgment can be effectively enhanced and the efficiency of visual judgments by an operator can be improved.

In addition, the present invention is a device that performs an appearance inspection of a board, the device comprising: image pickup device for picking up an image of the board; memory for storing standard image data to be used as a standard of a good board; an automatic judgment device for comparing a picked-up image of the board picked up by the image pickup device with standard image data stored in advance in the memory to judge whether the board is good or poor; and controller for additionally storing a picked-up image of a board judged to be poor by the an automatic judgment device but then judged to be good in a visual judgment by the operator in the memory as the standard image data.

According to the board inspection device of the present invention, a board appearance inspection can be efficiently performed with a simple structure.

The inspection device according to the present invention preferably further comprises: display for displaying an image of a board judged to be a poor board by the an automatic judgment device; and input device for the operator performing a visual judgment on whether the board is good or poor based on the image displayed on the display to input the judgment result, wherein when the judgment result inputted via the input device is a good board, a picked-up image of the board judged to be a good board is additionally stored in the memory as the standard image data.

According to this configuration, since an automatic judgment and a visual judgment of a board can be performed at the same device, an advantage may be achieved in that a board appearance inspection can be efficiently performed with a simple and compact structure.

In addition, the inspection device according to the present invention preferably further comprises a board-holding mechanism for moving a board between a home position at which attaching/detaching of the board is performed and an inspection position at which an image of the board is picked up by the image pickup device, wherein the board-holding mechanism and the respective aforementioned devices are integrally assembled so as to be portable.

As shown, when a board-holding mechanism that moves a board between the home position and the inspection position is provided, since merely setting the board to the home position causes a subsequent series of operations or, in other words, operations such as movement of the board to the inspection position or restoration of the board to the home position after image pickup to be automatically executed, the usability of the inspection device can be effectively improved. In addition, since the board-holding mechanism and the respective devices are integrally assembled so as to be portable, an advantage may be achieved in that the space occupied by the device can be reduced and the inspection device can be used anywhere without discrimination.

Furthermore, the present invention is a board inspection system comprising a plurality of the board inspection devices described above and a visual judgment machine commonly provided for the plurality of board inspection devices, wherein the visual judgment machine includes display for collectively displaying images of boards respectively judged to be poor by the plurality of board inspection devices and input device for the operator performing a visual judgment on the boards based on the image displayed on the display to input the judgment result, and the inspection devices read out the judgment result at the visual judgment machine and performs a predetermined operation according to the result.

According to the present invention, since images of boards respectively judged to be poor boards by the plurality of board inspection devices are arranged to be collectively displayed on the display of the common visual judgment machine, the operator can now visually judge a board while constantly viewing the display of the same visual judgment machine regardless of whether a poor board has occurred at any of the inspection devices, and upon the occurrence of a poor board, the operator is no longer required to move to the inspection machine corresponding to the board to perform a visual judgment. As a result, a plurality of boards can now be concurrently inspected and a board inspection system with greater workability may be achieved.

The visual judgment machine is preferably provided at one of the plurality of inspection devices.

Accordingly, an advantage may be achieved in that a board inspection can be efficiently performed while reducing the space occupied by the system.

With the board inspection system according to the present invention, the memory is preferably provided commonly to the plurality of inspection devices and standard image data common to the respective inspection devices collectively stored in the memory.

Accordingly, since boards to be judged by the respective inspection devices can now be judged as to whether the boards are good or poor based on common standard image data, an advantage may be achieved in that variations in judgment standards among the respective inspection devices can be avoided and inspections on the boards can be performed efficiently.

Furthermore, in the board inspection device according to the present invention, the display preferably displays, together with the image of the board, a reference image that can be referenced during the visual judgment.

According to this configuration, the accuracy of a visual judgment by the operator can be further stabilized.

Moreover, the present invention is an image display device comprising: image pickup device for picking up an image of a board; memory for storing standard image data to be used as a standard for judging whether the state of the board is good or poor; image processor for comparing a picked-up image of the board picked up by the image pickup device with the standard image data stored in the memory to determine a difference, and creating a difference image based on the difference; and display for concurrently displaying the difference image and a reference image that can be referenced during the good/poor judgment.

According to such a configuration, by having the image processor create a difference image based on a difference between image data of a picked-up image of a board obtained in the image pickup step and standard image data stored in the memory, and by having the display concurrently display the difference image and the reference image, the difference between the picked-up image of the board and the standard image can be highlighted and judgment can be performed while referencing the reference image. Therefore, the accuracy of good/poor judgment by the operator can be stabilized and, at the same time, the efficiency of an inspection can be improved.

The following configurations are favorable as embodiments of the present invention.

A configuration is possible in which the image processor creates a standard image based on standard image data, while the display displays the standard image as a reference image. According to such a configuration, since it is now possible to compare a difference image with the standard image, good/poor judgment can be performed with greater ease as compared to judging solely by the difference image.

The display may be configured so as to display a picked-up image of the board as a reference image. According to such a configuration, since it is possible to reference a picked-up image of the board in addition to a reference image, an appropriate good/poor judgment can be performed with greater ease as compared to judging solely by a difference image.

A configuration is also possible in which the memory is capable of storing normal image data indicating a normal state of a board, the image processor creates a standard image based on the normal image data, and the display displays the normal image as a reference image. According to such a configuration, since it is now possible to compare a difference image with the normal image, good/poor judgment can be performed with greater ease as compared to judging solely by the difference image.

A configuration is also possible in which the memory is capable of storing a plurality of types of standard image data, while the image processor creates a difference image based on a single type of standard image data selected from the plurality of types of standard image data. According to such a configuration, standard image data suitable for good/poor judgment can be selected. In addition, the difference image created in this manner can also be concurrently displayed on the display with a plurality of standard images.

A configuration is also possible in which the memory is capable of storing normal image data indicating a normal state of a board, the image processor creates a difference image using normal image data as standard image data, and the display displays the difference image. According to such a configuration, the difference between the picked-up image of a board and a normal image can be highlighted.

The board inspection device may be configured so as to comprise: an automatic judgment device for comparing image data of a picked-up image of a board with standard image data, and by studying the consistency thereof, judging whether the states of inspection objects placed on the board are good or poor; and the image display device described above, wherein the image processor creates a difference image on an inspection object judged to be poor by the an automatic judgment device. According to such an inspection device, since it is no longer necessary to visually judge all inspection objects, it is possible to visually judge only inspection objects judged to be poor by the an automatic judgment device. Therefore, inspection efficiently can be significantly increased as compared to performing visual judgments on all objects.

The cream solder printing machine may be configured to comprise: printer for printing a cream solder at a predetermined position on a board; and the image display device for displaying an image to be used as an aid for visually judging the printing state of the cream solder printed on the board by the printer, or may alternatively be configured to comprise: printer for printing a cream solder at a predetermined position on a board; and the inspection device for inspecting the printing state of the cream solder printed on the board by the printer. According to such a cream solder printing machine, a printing state of a cream solder can be inspected after the cream solder is printed on a board to judge whether the printing state is good or poor.

## Claims

1. A board appearance inspection method comprising:
an image pickup step for picking up an image of the board using image pickup device;
an automatic judgment step for causing an automatic judgment device to execute processing for comparing a picked-up image of the board obtained in the image pickup step with standard image data stored in a memory as a standard of a good board to judge whether the board is good or poor; and
a visual judgment step for displaying an image of the board on a display when the board is judged to be poor in the automatic judgment step to have an operator perform a visual judgment to judge whether the board is good or poor based on the image displayed on the display,
wherein when the board is judged to be good in the visual judgment step, a picked-up image of the board judged to be good is additionally stored in the memory as the standard image data.

2. The board appearance inspection method according to claim 1, wherein
the automatic judgment step is a step in which a picked-up image of the board and standard image data are compared to determine a difference, and whether the board is good or poor is judged based on the difference image.

3. The board appearance inspection method according to claim 2, wherein
the automatic judgment step is a step in which a picked-up image of each of a plurality of partitions obtained by dividing a picked-up image of the board into a plurality of partitions is compared with standard image data similarly stored for each partition to determine a difference, and whether the board is good or poor is judged based on the extracted difference image of each partition.

4. The board appearance inspection method according to claim 2 or 3, wherein
in the visual judgment step, a difference image obtained by comparing a picked-up image of the board with standard image data is to be displayed on the display, and
the difference image to be displayed on the display is a difference image colored in a different color in accordance with difference characteristics.

5. A board appearance inspection device comprising:
an image pickup device for picking up an image of the board;
a memory for storing standard image data to be used as a standard of a good board;
an automatic judgment device for comparing a picked-up image of the board picked up by the image pickup device with standard image data stored in advance in the memory to judge whether the board is good or poor; and
a controller for additionally storing a picked-up image of a board judged to be poor by the an automatic judgment device but then judged to be good by a visual judgment by the operator in the memory as the standard image data.

6. The board inspection device according to claim 5, further comprising:
a display for displaying an image of a board judged to be a poor board by the an automatic judgment device; and
an input device for the operator performing a visual judgment on whether the board is good or poor based on the image displayed on the display to input the judgment result, wherein
when the judgment result inputted via the input device is a good board, the controller causes a picked-up image of the board judged to be a good board to be additionally stored in the memory as the standard image data.

7. The board inspection device according to claim 5 or 6, further comprising:
a board-holding mechanism for moving a board between a home position at which attaching/detaching of the board is performed and an inspection position at which an image of the board is picked up by the image pickup device, wherein
the board-holding mechanism and the respective aforementioned devices are integrally assembled so as to be portable.

8. A board inspection system comprising a plurality of the board inspection devices according to claim 5 and a visual judgment machine commonly provided for the plurality of the board inspection devices, wherein
the visual judgment machine includes a display for collectively displaying images of boards respectively judged to be poor by the plurality of board inspection devices and input device for the operator performing a visual judgment on the boards based on the image displayed on the display to input the judgment result, and
the inspection device reads out the judgment result at the visual judgment machine and performs a predetermined operation according to the result.

9. The board inspection system according to claim 8, wherein
the visual judgment machine is provided at one of the plurality of inspection devices.

10. The board inspection system according to claim 8 or 9, wherein
the memory is provided commonly to the plurality of inspection devices, and standard image data common to the respective inspection devices are collectively stored in the memory.

11. The board inspection device according to claim 6, wherein
the display displays, together with the image of the board, a reference image that can be referenced during the visual judgment.

12. An image display device comprising:
an image pickup device for picking up an image of a board;
a memory for storing standard image data to be used as a standard for judging whether the state of the board is good or poor;
an image processor for comparing an image data of a picked-up image of the board picked up by the image pickup device with the standard image data stored in the memory to determine a difference, and creating a difference image based on the difference; and
a display for concurrently displaying the difference image and a reference image that can be referenced during the good/poor judgment.

13. The image display device according to claim 12, wherein
the image processor creates a standard image based on the standard image data, and the display displays the standard image as the reference image.

14. The image display device according to claim 12 or 13, wherein
the display displays a picked-up image of the board as the reference image.

15. The image display device according to any one of claims 12 to 14, wherein
the memory is capable of storing normal image data indicating a normal state of the board, the image processor creates a normal image based on the normal image data, and the display displays the normal image as the reference image.

16. The image display device according to any one of claims 12 to 15, wherein
the memory is capable of storing a plurality of types of the standard image data, and the image processor creates the difference image based on a single type of standard image data selected from the plurality of types of the standard image data.

17. The image display device according to any one of claims 12 to 16, wherein
the memory is capable of storing normal image data indicating a normal state of the board, and the image processor creates a difference image using the normal image data as the standard image data.

18. A board inspection device comprising:
an automatic judgment device for comparing image data of a picked-up image of the board with the standard image data, and by studying the consistency thereof, judging whether the states of inspection objects placed on the board are good or poor; and
the image display device according to any one of claims 12 to 17, wherein
the image processor creates the difference image on an inspection object judged to be poor by the automatic judgment device.

19. A cream solder printing machine comprising: a printer for printing a cream solder at a predetermined position on a board; and the image display device according to any one of claims 12 to 17 for displaying an image to be used as an aid for visually judging the printing state of the cream solder printed on the board by the printer.

20. A cream solder printing machine comprising: a printer for printing a cream solder at a predetermined position on a board; and the inspection device according to claim 18 for inspecting the printing state of the cream solder printed on the board by the printer.

21. An image display method for displaying an image to be used by an operator as an aid for visually judging whether the state of a board is good or poor, the method comprising:
an image pickup step for picking up an image of a board using an image pickup device;
a difference image creating step for comparing standard image data stored in advance in memory as a standard for judging whether the state of the board is good or poor and an image data of a picked-up image of the board picked up in the image pickup step to determine a difference, and creating a difference image based on the difference using image processor; and
an image display step for concurrently displaying the difference image and a reference image that can be referenced during the good/poor judgment on display.
